# EUROPÄISCHE PATENTSCHRIFT

(11) **EP 3 953 724 B1**
(45) Veröffentlichungstag und Bekanntmachung des Hinweises auf die Patenterteilung: **14.09.2022**
(21) Anmeldenummer: 21703609.4
(22) Anmeldetag: 26.01.2021
(51) Int. Cl.: G01R 33/3815, G01R 33/3875, H01F 6/04

(54) **NMR-MESSANORDNUNG MIT KALTER BOHRUNG DES KRYOSTATEN**
NMR MEASURING ASSEMBLY WITH COLD BORE OF THE CRYOSTAT
ENSEMBLE DE MESURE À RÉSONANCE MAGNÉTIQUE NUCLÉAIRE (RMN) À TROU FROID DU CRYOSTAT

(30) Priorität: 07.02.2020 DE 102020201522
(43) Veröffentlichungstag der Anmeldung: 16.02.2022
(73) Patentinhaber: Bruker Switzerland AG, 8117 Fällanden (CH)
(72) Erfinder: WIKUS, Patrick, 8309 Nürensdorf (CH)
(74) Vertreter: Kohler Schmid Möbus Patentanwälte
(86) Internationale Anmeldenummer: PCT/EP2021/051732
(87) Internationale Veröffentlichungsnummer: WO 2021/156103

(56) Entgegenhaltungen:
- EP-A1- 1 560 035
- DE-B3-102015 212 314
- DE-B3-102016 207 846
- DE-B3-102016 214 731
- DE-B3-102016 218 000

## Beschreibung

Die Erfindung betrifft eine NMR-Messanordnung, umfassend
- einen Kryostaten, mit einem evakuierten Vakuumbehälter, wobei der Kryostat eine Bohrung ausbildet, und wobei eine Wand der Bohrung den Vakuumbehälter mit begrenzt,
- ein supraleitendes Magnetspulensystem, mit einer Magnetbohrung, wobei das Magnetspulensystem direkt oder indirekt innen im Vakuumbehälter angeordnet ist, wobei der Kryostat zur thermischen Isolation des Magnetspulensystems zwischen dem supraleitenden Magnetspulensystem und dem Vakuumbehälter in Abfolge von innen nach außen lokal einen oder mehrere evakuierte Spalträume ausbildet, und wobei die Bohrung durch die Magnetbohrung hindurch verläuft,
- einen NMR-Probenkopf, mit einem HF-Spulensystem, wobei der NMR-Probenkopf außerhalb des Vakuumbehälters angeordnet ist, und wobei der NMR-Probenkopf zumindest teilweise in der Bohrung angeordnet ist.

Eine solche NMR-Messanordnung ist beispielsweise aus der US 2006/0021355 A1 bekannt geworden.

Mittels Kernspinresonanz(=NMR)-Messungen können in einer Messprobe enthaltene Substanzen qualitativ und quantitativ untersucht werden. Die Messprobe wird dabei einem statischen Magnetfeld ausgesetzt und mit Hochfrequenz(=HF)-Pulsen bestrahlt, und die Reaktion der Messprobe auf die HF-Pulse wird vermessen. Für eine hohe Genauigkeit der NMR-Messungen sollte das statische Magnetfeld homogen sein, über die Zeit stabil sein und eine möglichst hohe Feldstärke besitzen.

Magnetfelder hoher Feldstärken für NMR-Messungen werden oft mittels supraleitender Magnetspulensystemen erzeugt. Die supraleitenden Magnetspulensysteme müssen dabei auf einer kryogenen Temperatur gehalten werden, wofür die Magnetspulensysteme typischerweise in einem Kryostaten angeordnet werden. Ein typischer Kryostat umfasst einen Vakuumbehälter, in dessen Innerem direkt oder indirekt das Magnetspulensystem angeordnet ist, und dessen Inneres zur thermischen Isolation des Magnetspulensystems von der Umgebung evakuiert ist. Das Magnetspulensystem ist meist als Solenoid mit einer Magnetbohrung ausgebildet, in der zentral das Probenvolumen für die Messprobe mit einer maximalen Magnetfeldstärke ausgebildet ist. Der Kryostat bzw. der Vakuumbehälter bildet eine Bohrung aus, die durch die Magnetbohrung hindurch verläuft und über die das Probenvolumen zugänglich ist. In die Bohrung des Kryostaten wird ein NMR-Probenkopf angeordnet, insbesondere eingeschoben, der zumindest ein HF-Spulensystem aufweist, um HF-Pulse in die Messprobe einzustrahlen und die Reaktion der Messprobe auszulesen.

Der Vakuumbehälter bzw. dessen äußere Wand ist der Umgebung ausgesetzt und entsprechend näherungsweise auf Raumtemperatur. Um einen Wärmeeintrag durch Wärmestrahlung in das Magnetspulensystem zu minimieren, verfügt der Kryostat typischerweise über einen oder mehrere Metallblech-Strahlungsschilde, die zwischen dem Vakuumbehälter (bzw. dessen äußerer Wand) und dem Magnetspulensystem angeordnet sind. Beidseits eines Metallblech-Strahlungsschilds herrscht zur thermischen Isolation ein Vakuum, und das Metallblech-Strahlungsschild ist meist an eine Wärmesenke des Kryostaten angeschlossen.

Die US 2006/0021355 A1 beschreibt einen Kryostaten, bei dem ein supraleitendes Magnetspulensystem in einem mit flüssigem Helium befüllten Kryobehälter angeordnet ist, der von einer kälteste Kühlstufe eines Kryokühlers gekühlt wird. Der Kryobehälter ist allseits, einschließlich zur Bohrung des Kryostaten hin, von einem Metallblech-Strahlungsschild umgeben, der an eine wärmere Kühlstufe des Kryokühlers thermisch gekoppelt ist. Der Metallblech-Strahlungsschild ist wiederum im Vakuumbehälter des Kryostaten angeordnet. Das Magnetspulensystem kann insbesondere für die hochauflösende NMR ausgebildet sein.

Bei dieser Bauform ist die Bohrung des Kryostaten näherungsweise auf Raumtemperatur und der Umgebungsluft ausgesetzt, was die Anordnung und den Wechsel eines NMR-Probenkopfs in der Bohrung erleichtert.

Vergleichbare Kryostaten sind auch aus der US 5 220 800 A, der US 8 975 896 B2 und der US 6 192 690 B1 bekannt geworden, wobei im Vakuumbehälter des Kryostaten ein LN2-Tank angeordnet ist, der ein Metallblech-Strahlungsschild kühlt, wobei dieser Metallblech-Strahlungsschild zwischen einem Helium-befüllten Kryobehälter und der Wand des Vakuumbehälters verläuft, insbesondere im Bereich der Bohrung.

Um das Signal-zu-Rausch-Verhältnis bei den NMR-Messungen an der Messprobe zu verbessern, sind NMR-Probenköpfe bekannt geworden, bei denen die HF-Spulen des NMR-Probenkopfs mit einer eigenen Kühleinrichtung gekühlt werden. Das äußere Gehäuse des NMR-Probenkopfs kann dann zur thermischen Isolation als ein Vakuumbehälter ausgeführt werden, vgl. zum Beispiel die US 2007/0096740 A1; in dieser Druckschrift wird auch vorgeschlagen, ein Strahlungsschild innerhalb des NMR-Probenkopfs einzusetzen.

In der Magnetbohrung eines supraleitenden Magnetspulensystems einer NMR-Messanordnung müssen oder sollen je nach Bauform eine Vielzahl von Komponenten untergebracht werden, insbesondere die NMR-Messprobe (meist ein mit einer Messsubstanz gefülltes Probenröhrchen), Kanäle für eine Temperierung der Messprobe, Gaskanäle für eine Bewegung der Messprobe (etwa für eine Rotation der Messprobe während der Messung oder um die Messprobe ein- und auszuführen), Vakuum- und Gasbarrieren zur thermischen Isolation der Messprobe oder des HF-Spulensystems, das HF-Spulensystem, Wärmetauscher und Kühlelemente für das HF-Spulensystem, ein Gradienten-Spulensystem einschließlich einer etwaigen Abschirmung zur Einbringung von Gradientenpulsen auf die Messprobe, ein elektrisches Shim-Spulensystem zur Homogenisierung des statischen Magnetfelds, Gaskanäle zur Kühlung des Shim-Spulensystems, passive Shimelemente, elektrische Zuleitungen zum HF-Spulensystem und zum Shim-Spulensystem, und/oder Diagnosesensoren einschließlich Zuleitungen (etwa Temperatursensoren, Magnetfeldsensoren, optische Sensoren zur Erfassung der Probenposition). Je mehr Volumen innerhalb der Magnetbohrung für die Messprobe zur Verfügung steht, bzw. je näher das Magnetspulensystem an die Messprobe heranrücken kann, desto einfacher und billiger ist es möglich, mit dem Magnetspulensystem eine hohe Magnetfeldstärke an der Messprobe einzurichten. Je höhere die Magnetfeldstärke ist, desto genauere NMR-Messsignale (insbesondere mit höherer spektraler Auflösung und höherem Signal-zu-Rauschverhältnis) können von der Messprobe gewonnen werden.

Aus der DE 10 2016 214 728 B3 ist eine NMR-Apparatur bekannt geworden, die vorsieht, einen NMR-Probenkopf teilweise im Inneren des Vakuumbehälters eines Kryostaten anzuordnen. Im Vakuumbehälter des Kryostaten ist auch ein supraleitendes Magnetspulensystem angeordnet. Der Vakuumbehälter des Kryostaten kann dafür mit einer Schleusenanordnung versehen werden.

Nachteilig an letzterem Vorgehen ist die Gefahr, das Vakuum des Vakuumbehälters, in welchem auch die supraleitende Magnetspulenanordnung zur thermischen Isolation angeordnet ist, bei einem Wechsel des Probenkopfs versehentlich zu brechen, was in der Regel zu einem plötzlichen Anstieg der Wärmelast auf die Magnetspule und in direkter Folge zu einem Zusammenbruch der Supraleitung ("Quench") am supraleitenden Magnetspulensystem führt.

Die DE 10 2016 218 000 B3 beschreibt eine Kryostatenanordnung umfassend einen Vakuumbehälter und ein zu kühlendes Objekt, wie etwa einen supraleitenden Magneten. Das zu kühlende Objekt wird über einen Kaltkopf gekühlt und ist von einem thermischen Strahlungsschild umgeben. Die Kryostatenanordnung umfasst weiterhin eine Raumtemperaturbohrung.

Die DE 10 2015 212 314 B3 beschreibt eine Kryostatenanordnung umfassend einen ersten Behälter, in dem eine supraleitende Magnetanordnung vorliegt, welche mit einem ersten Kryogen gekühlt wird, und einem zweiten Behälter mit einem zweiten Kryogen, wobei das erste Kryogen bei einer niedrigeren Temperatur siedet als das zweite Kryogen. Der erste Behälter für das erste Kryogen ist von einem Strahlungsschild umgeben.

### Aufgabe der Erfindung

Es ist Aufgabe der Erfindung, eine NMR-Messanordnung vorzustellen, mit der genauere NMR-Messungen (insbesondere mit höherer spektraler Auflösung und/oder höherem Signal- zu-Rauschverhältnis) an Messproben gewonnen werden können.

### Beschreibung der Erfindung

Diese Aufgabe wird erfindungsgemäß gelöst durch eine NMR-Messanordnung der eingangs genannten Art,
wobei der Kryostat im Zwischenraum zwischen dem Magnetspulensystem und der Wand der Bohrung in Abfolge von innen nach außen, ausgehend vom Magnetspulensystem auf den Vakuumbehälter zu, lediglich einen evakuierten Spaltraum ausbildet,
wobei zumindest ein Teilstück der Wand der Bohrung an eine Wärmesenke des Kryostaten thermisch gekoppelt ist,
und wobei die Wand der Bohrung einen hermetisch abgedichteten Raum außerhalb des Vakuumbehälters mit begrenzt, wobei sich dieser abgedichtete Raum in der Bohrung in Längsrichtung zumindest über die Länge des Teilstücks erstreckt.

Im Rahmen der vorliegenden Erfindung ist es vorgesehen, im Zwischenraum zwischen der Wand der Bohrung des Vakuumbehälters und dem Magnetspulensystem zur thermischen Isolation lediglich einen evakuierten Spaltraum vorzusehen.

Mit anderen Worten, im Zwischenraum zwischen dem Magnetspulensystem und der Wand der Bohrung ist kein herkömmlicher Metallblech-Strahlungsschild (das ist ein beidseits von Vakuum umgebenes Metallblech, meist mit thermischer Kopplung des Metallblechs an eine Wärmesenke des Kryostaten) ausgebildet. Vielmehr liegen sich an dem lediglich einen evakuierten Spaltraum die Wand der Bohrung einerseits und andererseits das Magnetspulensystem oder ein mit Kryofluid befüllter Kryobehälter, in welchem das Magnetspulensystem angeordnet ist, unmittelbar gegenüber. Die Wand der Bohrung begrenzt somit den lediglich einen evakuierten Spaltraum.

Ein herkömmlicher Metallblech-Strahlungsschild, der beiderseits des Metallblechs jeweils einen evakuierten Spaltraum (also insgesamt zwei evakuierte Spalträume in Abfolge von innen nach außen) ausbilden würde, würde für die beiden evakuierten Spalträume vergleichsweise viel Bauraum benötigen (man beachte, dass evakuierte Spalträume groß genug eingerichtet werden müssen, so dass in allen Betriebszuständen und über die gesamte Betriebszeit des Kryostaten eine Wärmebrücke durch Festkörperkontakt ausgeschlossen ist, um ihre Isolationswirkung sicherzustellen). Dieser Bauraum kann im Rahmen der Erfindung teilweise eingespart werden und entsprechend teilweise dafür genutzt werden, einen größeren Anteil des Volumens im Inneren der Magnetbohrung für die Vermessung der Messprobe (und insbesondere für die Messprobe selbst) zu nutzen und mit dem Magnetspulensystem näher an die zu vermessende Messprobe heranzurücken. Dadurch wird die Magnetfelderzeugung durch das Magnetspulensystem an der Messprobe effizienter; insbesondere können unter sonst gleichen Bedingungen (insbesondere bei gleichen Kosten) höhere Magnetfeldstärken an der Messprobe eingerichtet werden, und entsprechend können genauere NMR-Messungen an der Messprobe, die in der Bohrung zusammen mit dem NMR-Probenkopf angeordnet wird, im Rahmen der Erfindung erfolgen.

Typischerweise verfügt der Kryostat gemäß der Erfindung zwischen dem Vakuumbehälter und dem Magnetspulensystem über wenigstens einen Metallblech-Strahlungsschild, welcher im Bereich des Zwischenraums zwischen Magnetspulensystem und der Wand der Bohrung unterbrochen ist. Im Zwischenraum zwischen dem Magnetspulensystem und der Wand der Bohrung können jedoch im Rahmen der Erfindung, falls gewünscht, eine oder mehrere Superisolationsfolien (etwa ein Paket aus mit Al beschichteten, biaxial orientierten Polyesterfolien) eingesetzt werden, die beispielsweise innenseitig (vakuumseitig, radial außen) die Wand der Bohrung bedecken.

Weiterhin ist im Rahmen der Erfindung vorgesehen, zumindest ein Teilstück der Wand der Bohrung des Vakuumbehälters an eine Wärmesenke des Kryostaten zu koppeln. In Normalbetrieb ist also die Wand der Bohrung zumindest im Bereich dieses Teilstücks kalt, insbesondere deutlich kälter als Raumtemperatur bzw. als die Temperatur der Umgebung. Durch die thermische Kopplung zumindest des Teilstücks an die Wärmesenke kann das Fehlen eines herkömmlichen Metallblech-Strahlungsschilds im Bereich der Bohrung zumindest teilweise ausgeglichen werden, und der Wärmeeintrag auf das Magnetspulensystem kann im Rahmen der Erfindung auf ein technisch handhabbares und wirtschaftliches Maß beschränkt werden. Die Wärmesenke des Kryostaten, an die zumindest das Teilstück thermisch gekoppelt ist, ist vom Magnetspulensystem thermisch entkoppelt, so dass der Wärmeeintrag in das Magnetspulensystem minimiert wird.

Zudem ist im Rahmen der Erfindung vorgesehen, dass die Wand der Bohrung einen hermetisch abgedichteten Raum außerhalb des Vakuumbehälters mit begrenzt, wobei sich dieser abgedichtete Raum in der Bohrung in Längsrichtung zumindest über die Länge des Teilstücks erstreckt. Mit anderen Worten, die Bohrung ist zumindest im Bereich des Teilstücks der Wand der Bohrung gegenüber der Umgebung und dem evakuierten Raum des Vakuumbehälters hermetisch abgedichtet. Dadurch ist es möglich, diesen abgedichteten Raum frei von Feuchtigkeit zu halten, und eine Kondenswasserbildung oder gar Eisbildung an der kalten Wand der Bohrung auf der dem Vakuumbehälter abgewandten Seite zu verhindern oder zumindest zu minimieren. Typischerweise ist der hermetisch abgedichtete Raum im Normalbetrieb evakuiert oder mit einem Trockengas gefüllt, bevorzugt mit einem Überdruck gegenüber der Umgebung, um ein Eindringen von Umgebungsluft im Falle einer Undichtigkeit zu erschweren. Bevorzugt wird im Falle einer Füllung mit Trockengas ein konstanter Überdruck im abgedichteten Raum gegenüber der Umgebung eingestellt, und falls zur Aufrechterhaltung des konstanten Überdrucks ein Gaszustrom nötig ist, ist dies ein Indiz für ein Leck. Während Manipulationen am Probenkopf (z.B. Einbau oder Ausbau) durchgeführt werden, kann der hermetisch abgedichtete Raum eröffnet und mit einem Trockengas gespült werden. Die Begrenzung des abgedichteten Raums erfolgt typischerweise zusammen mit weiteren Strukturen (etwa einem Bohrungsboden oder einem Verschlussdeckel). Insbesondere kann der NMR-Probenkopf den abgedichteten Raum mit begrenzen; alternativ kann auch der NMR-Probenkopf vollständig im abgedichteten Raum angeordnet sein. Für die elektrischen Anschlüsse und etwaige Fluidanschlüsse des NMR-Probenkopfs können hermetische Durchführungen verwendet werden. Die Länge des Teilstücks bezieht sich auf die Längsrichtung (axiale Richtung entlang der Bohrungsachse).

Der NMR-Probenkopf kann neben dem HF-Spulensystem weiterhin ein Shim-Spulensystem umfassen, oder ein Shim-Spulensystem wird ebenfalls in der Bohrung angeordnet. Der NMR-Probenkopf kann außerdem ein Gradienten-Spulensystem umfassen, oder ein Gradienten-Spulensystem wird ebenfalls in der Bohrung angeordnet. Dass der NMR-Probenkopf außerhalb des Vakuumbehälters angeordnet ist, hat den Vorteil, dass Manipulationen (etwa ein Probenwechsel, eine Justage oder eine Reparatur) am NMR-Probenkopf relativ einfach durchgeführt werden können, und dass bei etwaigen Störungen am NMR-Probenkopf (z.B. Lecks in gasführenden Komponenten) das Isolationsvakuum im Kryostaten für das Magnetspulensystem nicht gefährdet ist. Der NMR-Probenkopf kann eine Probenhalterung umfassen. Bevorzugt ist der NMR-Probenkopf bei einem Probenkopfwechsel als einheitliches Bauteil handhabbar, und insbesondere in die Bohrung ein- und ausführbar, bevorzugt in axialer Richtung.

Das supraleitende Magnetspulensystem kann im evakuierten Innenraum des Vakuumbehälters direkt angeordnet werden (d.h. das Magnetspulensystem ist dem Isolationsvakuum im Vakuumbehälter direkt ausgesetzt), oder indirekt angeordnet werden (d.h. in einem Kryobehälter, der im Innerraum des Vakuumbehälters angeordnet ist und mit einem Kryofluid, meist Helium, befüllt ist, so dass das Magnetspulensystem diesem Kryofluid ausgesetzt ist). Der Kryostat kann einen weiteren Kryobehälter, meist gefüllt mit flüssigem Stickstoff, umfassen.

Die erfindungsgemäße NMR-Messanordnung ist bevorzugt für die die hochauflösende NMR-Spektroskopie mit einer 1H Resonanzfrequenz von 1,2 GHz oder höher ausgebildet. Das supraleitende Magnetspulensystem kann einen HTS-Leiter, insbesondere einen YBCO-Bandleiter, umfassen, der auf einen Durchmesser von 70 mm oder weniger gewickelt ist.

Die "Abfolge von innen nach außen" (über welche die Anzahl der evakuierten Spalträume gezählt wird) bezieht sich allgemein auf eine (lokale) Richtung ausgehend vom Magnetspulensystem (das "innen" im Vakuumbehälter liegt) auf den Vakuumbehälter bzw. dessen Wand zu (wobei der Vakuumbehälter das Magnetspulensystem umgibt und daher gesehen vom Magnetspulensystem "außen" liegt). Im besagten Zwischenraum zwischen dem Magnetspulensystem und der Wand der Bohrung ist die "Abfolge von innen nach außen" somit ausgehend vom Magnetspulensystem auf die Bohrung zu gerichtet, also nach "radial innen".

### Bevorzugte Ausführungsformen der erfindungsgemäßen NMR-Messanordnung

Bevorzugt ist eine Ausführungsform, bei der die Wand der Bohrung und eine Gehäusewand des NMR-Probenkopfs mit einer oder mehreren Dichtungen, insbesondere Radialdichtungen, gegeneinander abgedichtet sind. Im Zusammenspiel mit der (gasdichten) Gehäusewand des NMR-Probenkopfs und der oder den Dichtungen kann auf einfache Weise der abgedichtete Raum begrenzt werden. Oftmals ist ein Gehäuse des NMR-Probenkopfs insgesamt gasdicht ausgebildet; in anderen Fällen sind nur die dem abgedichteten Raum zugewandten Gehäusewände gasdicht ausgebildet. Typischerweise wird während eines Probenkopfwechsels eine vorübergehende Öffnung des abgedichteten Raums akzeptiert, meist begleitet von Schutzmaßnahmen wie einer Spülung mit Trockengas oder einem temporären Erwärmen der Wand der Bohrung mittels einer Heizeinrichtung, um eine Kondenswasserbildung zu vermeiden. Nötigenfalls wird nach Installation des NMR-Probenkopfs der abgedichtete Raum zunächst auf die gewünschten atmosphärischen Bedingungen gebracht (insbesondere mit Trockengas gefüllt oder evakuiert), bevor eine NMR-Messung begonnen wird. Radialdichtungen ermöglichen das (axiale) Einschieben des Probenkopfes, ohne die atmosphärischen Bedingungen im abgedichteten Raum zu verändern.

Ebenfalls bevorzugt ist eine Ausführungsform, bei der an einer Öffnung der Bohrung eine Schleusenkammer ausgebildet ist, durch die der NMR-Probenkopf zur zumindest teilweisen Anordnung in der Bohrung einschleusbar und wieder ausschleusbar ist. Über die Schleusenkammer ist der abgedichtete Raum bzw. die Bohrung zugänglich, ohne die atmosphärischen Bedingungen im abgedichteten Raum (in der Regel Vakuum oder Trockengas) zu verändern; der evakuierte Raum kann also auch bei einem Probenkopfwechsel unterbrechungsfrei unter den gewünschten atmosphärischen Bedingungen gehalten werden. Dadurch kann die kalte Wand der Bohrung vor Kondenswasserbildung geschützt werden und auch eine Wärmelast auf die mit dem Teilstück gekoppelte Wärmesenke vermieden werden.

Bei einer vorteilhaften Ausführungsform ist eine Pumpeinrichtung vorgesehen, mit der der abgedichtete Raum evakuierbar ist. Ein Vakuum im abgedichteten Raum bzw. in der Bohrung vor deren kalter Wand vermeidet Kondenswasserbildung und verringert zudem den Eintrag von Wärme in die Wand der Bohrung und damit zum supraleitenden Magnetspulensystem. Falls eine Schleusenkammer vorhanden ist, ist bevorzugt auch diese mit der Pumpeinrichtung evakuierbar.

Weiterhin vorteilhaft ist eine Ausführungsform, bei der eine Trockengas-Befüllungseinrichtung vorhanden ist, mit der der abgedichtete Raum mit einem Trockengas, insbesondere trockenem Stickstoff oder trockenem Helium, befüllbar ist. Die Befüllung mit Trockengas ist kostengünstiger und einfacher als die Aufrechterhaltung eines Vakuums, und vermeidet ebenfalls eine Kondenswasserbildung. Die Befüllung mit Trockengas hilft außerdem, das Eindringen von Umgebungsluft in den hermetisch abgedichteten Raum zu vermeiden, insbesondere wenn das Trockengas einen Überdruck gegenüber der Umgebungsluft aufweist. Zudem kann über das Trockengas eine gewisse thermische Kopplung zwischen der Wand der Bohrung und in der Bohrung angeordneten Komponenten (also eine Kühlung dieser Komponenten), etwa Teilen des Probenkopfs, eingerichtet werden, falls gewünscht. Falls eine Schleusenkammer vorhanden ist, ist bevorzugt auch diese mit der Trockengas-Befüllungseinrichtung mit Trockengas befüllbar. Man beachte, dass eine Trockengas-Befüllungseinrichtung oft auch als Trockengas-Spüleinrichtung genutzt werden kann, mit der der abgedichtete Raum während einer Eröffnung, etwa bei einem Probenkopfwechsel, mit Trockengas gespült werden kann.

Bevorzugt ist weiterhin eine Ausführungsform, bei der der Kryostat mit einer Trockengas-Spüleinrichtung versehen ist, mit der die Bohrung zumindest im Bereich des Teilstücks mit einem trockenen Gas, insbesondere trockenem Stickstoff oder trockenem Helium, gespült werden kann. Durch die Spülung zumindest des (kalten) Teilstücks der Wand der Bohrung kann eine Kondenswasserbildung an diesem Teilstück verhindert werden. Meist wird die Trockengas-Spüleinrichtung nur temporär eingesetzt, typischerweise wenn ein abgedichteter Raum der Bohrung während eines Probenkopfwechsels vorübergehend geöffnet werden muss; es ist aber auch möglich, die Trockengas-Spüleinrichtung im Normalbetrieb während einer NMR-Messung an einer Messprobe einzusetzen, insbesondere wenn die Bohrung offen ist. Hier wird typischerweise darauf geachtet, die Flussrate des Trockengases so klein wie möglich zu halten, um eine thermische Belastung der kalten Bohrungswand zu minimieren, wobei aber gleichzeitig ein ausreichender Schutz vor Kondenswasserbildung und Vereisung gewährleistet bleiben muss.

Vorteilhaft ist weiterhin eine Ausführungsform, bei der die Wand der Bohrung mit einer Heizeinrichtung, insbesondere einer elektrischen Heizeinrichtung, versehen ist, mit der zumindest das Teilstück der Wand der Bohrung aufheizbar ist, insbesondere wobei mit der Heizeinrichtung zumindest das Teilstück der Wand auf ihrer der Umgebung zugewandten Seite auf eine Temperatur von wenigstens 10°C aufheizbar ist. Durch die Erwärmung zumindest des Teilstücks der Wand der Bohrung mittels der Heizeinrichtung kann eine Kondenswasserbildung an diesem Teilstück verhindert werden; bei typischen Luftfeuchtigkeiten in der Umgebung bis ca. 70% genügt eine Erwärmung auf ca. 10°C, um eine Kondenswasserbildung zuverlässig zu vermieden. Dabei wird die Heizeinrichtung nur temporär eingesetzt, typischerweise wenn ein abgedichteter Raum der Bohrung während eines Probenkopfwechsels vorübergehend geöffnet werden muss. Die Heizeinrichtung kann auch dazu verwendet werden, die Bohrung von Kondenswasser oder Eis zu befreien, falls sich Kondenswasser oder Eis z.B. durch Fehlbedienung und/oder einen Defekt gebildet haben.

Besonders bevorzugt ist eine Ausführungsform, bei der zumindest das Teilstück der Wand der Bohrung vom übrigen Vakuumbehälter, entsprechend einem Raumtemperatur-Mantel des Vakuumbehälters, weitgehend thermisch entkoppelt ist, so dass eine verbleibende thermische Kopplung kleiner als 0,1 W/K ist. Durch die (weitgehende) thermische Entkopplung des Teilstücks verringert sich der Wärmefluss vom übrigen Vakuumbehälter in das Teilstück, und somit auch die Wärmelast auf die Wärmesenke, über die das Teilstück gekühlt wird. Außerdem wird so sichergestellt, dass sich kein Bereich des übrigen Vakuumbehälters über Gebühr abkühlt. Damit wird vermieden, dass es zu Kondenswasser- oder Eisbildung am übrigen Vakuumbehälter (bzw. außerhalb des hermetisch abgedichteten Bereichs) kommt. Die (weitgehende) thermischen Entkopplung ist typischerweise so eingerichtet, dass sich der Vakuumbehälter durch den Wärmeabfluss in das kalte Teilstück in keinem von Umgebungsluft umspülten Bereich um mehr als 10 K unterhalb der Umgebungstemperatur abkühlt, wenn sich das kalte Teilstück auf der Betriebstemperatur seiner Wärmesenke befindet. Ebenso kann die (weitgehende) thermische Entkopplung so eingerichtet sein, dass der Wärmefluss vom Vakuumbehälter in das kalte Teilstück weniger als 20 W beträgt, wenn der Vakuumbehälter und das kalte Teilstück eine Temperaturdifferenz von 200 K aufweisen (insbesondere wenn der Vakuumbehälter eine Temperatur von 300 K aufweist und das kalte Teilstück auf 100 K gehalten wird); die verbleibende thermische Kopplung ist dann entsprechend kleiner als 0,1 W/K.

Bevorzugt ist eine Weiterbildung dieser Ausführungsform, bei der die Wand der Bohrung bezüglich der Längsrichtung in einem mittleren Teilbereich aus einem Material mit höherer spezifischer thermischer Leitfähigkeit und/oder mit einer größeren Wandstärke gefertigt ist als in zwei äußeren Teilbereichen. Durch diesen Aufbau ist es möglich, den mittleren Teilbereich (bzw. zumindest das Teilstück) gleichmäßig kalt zu halten und etwaige Wärmeeinstrahlung von radial innen, etwa vom Probenkopf her, schnell an die angekoppelte Wärmesenke abzuführen. Andererseits ist der axiale Eintrag von Wärme aus dem Vakuumbehälter bzw. dessen übriger Wand reduziert. Mittlerer und äußerer Teilbereich bezieht sich auf die Längsrichtung (axiale Richtung) der Bohrung. Falls ein Teilbereich der Wand der Bohrung aus mehreren Materialien gefertigt ist, kann eine Mittelung der Materialeigenschaften erfolgen. Typischerweise ist auch die übrige Wand des Vakuumbehälters aus einem Material mit höherer spezifischer thermischer Leitfähigkeit und/oder mit einer größeren Wandstärke gefertigt ist als in den zwei äußeren Teilbereichen. Die äußeren Teilbereiche können insbesondere als Wellenbalg ausgeführt sein und/oder aus Edelstahl oder enthaltend Edelstahl ausgebildet sein. Eine Ausführung als Wellenbald bringt den zusätzlichen Vorteil, dass die für die Wärmeleitung relevante Wegstrecke (die "thermische Distanz" zwischen kaltem Teilstück und dem Vakuumbehälter) verlängert wird. Der mittlere Teilbereich kann insbesondere aus Kupfer oder enthaltend Kupfer ausgeführt sein. Die Wärmeleitfähigkeit wird bei Betriebstemperatur der Wand der Bohrung zumindest am Teilstück verglichen, typischerweise bei ca. 40K-250 K, meist 40K-100K zumindest am Teilstück.

Weiterhin bevorzugt ist eine Ausführungsform, bei der die Wand der Bohrung bezüglich der Längsrichtung in einem mittleren Teilbereich auf ihrer radial außen liegenden Seite mit einer Beschichtung versehen ist, die eine höhere spezifische Wärmeleitfähigkeit aufweist als eine Grundstruktur der Wand der Bohrung, insbesondere wobei die Beschichtung aus Kupfer gefertigt ist und die Grundstruktur der Wand der Bohrung aus Edelstahl. Durch diesen Aufbau ist es wiederum möglich, den mittleren Teilbereich (bzw. das Teilstück) gleichmäßig kalt zu halten und etwaige Wärmeeinstrahlung von radial innen, etwa vom Probenkopf her, schnell an die angekoppelte Wärmesenke abzuführen. Die radial außen liegende Seite der Wand der Bohrung ist dem Vakuum im Vakuumbehälter zugewandt. Die Grundstruktur ist meist ein rundes Rohr bzw. Rohrstück. Die Wärmeleitfähigkeit wird bei Betriebstemperatur der Wand der Bohrung zumindest am Teilstück verglichen, typischerweise bei ca. 40K-250 K, meist 40K-100K zumindest am Teilstück.

Bevorzugt ist eine Weiterbildung dieser Ausführungsform, bei der die Beschichtung zumindest in einem Bereich um ein magnetisches Zentrum des Magnetspulensystems herum mit in Längsrichtung der Bohrung verlaufenden Unterbrechungen ausgebildet ist. Der Bereich um das magnetische Zentrum des Magnetspulensystems herum erstreckt sich in Längsrichtung typischerweise zumindest über einen aktiven Bereich des HF-Spulensystems (das ist der Bereich, in welchem das HF-Spulensystem mit einem HF-Puls die Kernspins in der Messprobe anregen kann und aus welchem die HF-Spulenanordnung Signale der Messprobe empfangen kann). Durch die Unterbrechungen können elektrische Kreisströme in der (elektrisch hoch leitfähigen) Beschichtung vermieden werden, die die NMR-Messung beeinträchtigen könnten. Der Bereich um das magnetische Zentrum erstreckt sich entlang der z-Richtung (Feldrichtung, entspricht im Allgemeinen der Richtung der Bohrungsachse) typischerweise über +/- 10 cm bis +/-30 cm beiderseits des Zentrums, bevorzugt ca. +/- 20 cm beiderseits des Zentrums.

Bevorzugt ist eine Ausführungsform, bei der die Wärmesenke, an die zumindest das Teilstück der Wand der Bohrung thermisch gekoppelt ist,
- ein Stickstoffbehälter des Kryostaten oder ein mit dem Stickstoffbehälter verbundener Strahlungsschild des Kryostaten ist, oder
- eine wärmere Kühlstufe eines Kryokühlers oder ein mit einer wärmeren Kühlstufe eines Kryokühlers verbundener Strahlungsschild ist, insbesondere wobei der Kryokühler als Pulsrohrkühler ausgebildet ist, oder
- ein Strahlungsschild, welcher durch abdampfendes Helium aus einem Kryobehälter gekühlt wird, wobei der Kryobehälter im Vakuumbehälter angeordnet ist und das Magnetspulensystem enthält. Diese Gestaltungen haben sich in der Praxis bewährt. Die besagten Strahlungsschilde sind in der Regel als Metallblech-Strahlungsschilde ausgeführt. Wenn die NMR-Messanordnung einen mehrstufigen Kryokühler aufweist, so ist das Magnetspulensystem typischerweise an eine kältere (insbesondere kälteste) Kühlstufe des Kryokühlers thermisch gekoppelt.

Bei einer vorteilhaften Ausführungsform ist zumindest das Teilstück der Wand der Bohrung thermisch gekoppelt an
- zumindest einen Teil des NMR-Probenkopfs, und/oder
- ein Gradienten-Spulensystem, welches separat vom Probenkopf oder als Teil des Probenkopfs in der Bohrung angeordnet ist, und/oder
- ein Shim-Spulensystem, welches separat vom Probenkopf oder als Teil des Probenkopfs in der Bohrung angeordnet ist. Durch die thermische Kopplung an zumindest das Teilstück der Wand der Bohrung kann im Normalbetrieb eine Kühlung der gekoppelten Komponente(n), etwa des HF-Spulensystems und/oder des Gradienten-Spulensystems und/oder des elektrischen Shim-Spulensystems, mit geringem Aufwand erreicht werden. Dadurch können gegebenenfalls eigene, lokale Kühlsysteme am NMR-Probenkopf eingespart werden; bevorzugt ist der NMR-Probenkopf dann ganz ohne eigene, lokale Kühlsysteme ausgebildet, wodurch wiederum Bauraum eingespart werden kann. Durch die Kühlung der gekoppelten Komponente(n) kann das Signal-zu-Rauschverhältnis der NMR-Messungen verbessert werden.

Besonders bevorzugt ist eine Ausführungsform, bei der sich das Teilstück der Wand in Längsrichtung der Bohrung zumindest über eine Länge eines aktiven Bereichs des HF-Spulensystems erstreckt. Im aktiven Bereich des HF-Spulensystems wird die Messprobe angeordnet, so dass der zugehörige Bauraum für eine genaue NMR-Messung der Messprobe besonders wertvoll ist.

Bevorzugt ist zudem eine Ausführungsform, bei der sich das Teilstück der Wand in Längsrichtung der Bohrung zumindest über eine Länge des Magnetspulensystems erstreckt. Im Falle einer zylindrischen Bohrung und einer zylindrischen Magnetbohrung, was in der Praxis häufig vorkommt, kann mit dieser Bauform die Größe (Durchmesser) der Bohrung maximiert werden und die Wärmeeinstrahlung auf das Magnetspulensystem besonders klein gehalten werden.

### Erfindungsgemäße Verwendungen

In den Rahmen der vorliegenden Erfindung fällt auch die Verwendung einer erfindungsgemäßen, oben beschriebenen NMR-Messanordnung, die dadurch gekennzeichnet ist,
dass an einer im NMR-Probenkopf angeordnete Messprobe eine NMR-Messung durchgeführt wird,
wobei während der Messung zumindest das Teilstück der Wand der Bohrung auf eine Temperatur T_{wand}<250K, insbesondere T_{wand}<100K, abgekühlt ist, und die Bohrung zumindest im Bereich des Teilstücks evakuiert ist oder mit einem Trockengas befüllt ist oder mit einem Trockengas gespült wird. Im Rahmen dieser Verwendung ist es möglich, von der Messprobe (auch einfach Probe genannt) eine genaue NMR-Messung zu erhalten, und gleichzeitig den Wärmeeintrag in das Magnetspulensystem auf ein technisch machbares und wirtschaftlich vernünftiges Maß zu reduzieren. Insbesondere kann ein großer Anteil der Magnetbohrung von der Messprobe eingenommen werden bzw. für die Vermessung der Messprobe eingesetzt werden, und das supraleitende Magnetspulensystem kann nahe an die Messprobe heranrücken, wodurch die Einrichtung einer hohen Magnetfeldstärke an der Messprobe vereinfacht wird.

Bevorzugt ist eine Variante der erfindungsgemäßen Verwendung, bei der während der Messung zumindest ein Teil des NMR-Probenkopfs durch thermische Kopplung zumindest an das Teilstück der Wand der Bohrung gekühlt wird. Dadurch kann auf einfache und kostengünstige Weise das Signal-zu-Rauschverhältnis der Messung (NMR-Messung) verbessert werden. Die thermische Kopplung kann bevorzugt durch eine gegenseitige Berührung von Probenkopf und Wand der Bohrung erfolgen; alternativ oder zusätzlich kann ein in der Bohrung enthaltenes Trockengas eine thermische Kopplung vermitteln oder verstärken.

In einer anderen, vorteilhaften Variante ist vorgesehen, dass zumindest ein Teil des NMR-Probenkopfs mittels einer eigenen Kühlvorrichtung gekühlt wird, wobei zumindest das Teilstück der Wand der Bohrung einen Eintrag von Wärmestrahlung in den NMR-Probenkopf begrenzt. Mit der eigenen Kühlvorrichtung ist ebenfalls eine Kühlung und dadurch Verbesserung des Signal-zu-Rausch-Verhältnisses der Messung (NMR-Messung) möglich. Ein Kryokühler des Kryostaten wird durch die Kühlung des NMR-Probenkopfs dann weniger oder gar nicht belastet.

Die vorliegende Erfindung umfasst zudem die Verwendung einer erfindungsgemäßen, oben beschriebenen NMR-Messanordnung mit abgedichtetem Raum und Schleusenkammer, die dadurch gekennzeichnet ist, dass der NMR-Probenkopf an der NMR-Messanordnung gewechselt wird, wobei ein erster NMR-Probenkopf aus der Bohrung ausgeführt und durch die Schleusenkammer ausgeschleust wird und ein zweiter NMR-Probenkopf durch die Schleusenkammer eingeschleust und zumindest teilweise in die Bohrung eingeführt wird, und währenddessen in der Bohrung zumindest im Bereich des Teilstücks der Wand der Bohrung ein Vakuum oder eine Trockengasfüllung vorgehalten wird. Der abgedichtete Raum wird im Rahmen des Schleusprozesses zur Schleusenkammer hin geöffnet und wieder verschlossen; dabei ist in der Schleusenkammer die gleiche Bedingung (Vakuum oder Trockengas) eingerichtet wie im abgedichteten Raum. Dieses Vorgehen verhindert besonders zuverlässig eine Kondenswasserbildung am (kalten) Teilstück, erfordert jedoch für die Schleusprozesse eine gewisse Zeit. Die gewünschten atmosphärischen Bedingungen am kalten Teilstück bleiben durchgehend erhalten. NMR-Messanordnungen mit Schleusenkammer können insbesondere für NMR-Probenköpfe eingesetzt werden, in denen die Messprobe "eingebaut" wird, und zum Ein- und Ausführen der Messprobe in die Bohrung der NMR-Probenkopf mitsamt der Messprobe in die Bohrung ein- und ausgeführt wird. In diesem Fall kann im Rahmen eines Probenwechsels der zweite NMR-Probenkopf derselbe Probenkopf wie der erste NMR-Probenkopf sein, jedoch mit einer anderen, in den Probenkopf eingebauten Messprobe. Bevorzugt werden jedoch zur aufeinanderfolgenden Vermessung verschiedener Messproben mehrere NMR-Probenköpfe vorgehalten, um hauptzeitparallel, d.h. parallel zu NMR-Messungen an einem (ersten) NMR-Probenkopf, an einem weiteren (zweiten) NMR-Probenkopf eine vermessene Messprobe ausbauen und eine noch zu vermessende Messprobe einbauen zu können; bevorzugt werden entsprechend der erste NMR-Probenkopf und zweite NMR-Probenkopf durch zwei separate Probenköpfe ausgebildet (gilt auch für die folgenden Verwendungen). Man beachte jedoch, dass in anderen Bauformen von NMR-Messanordnungen ein Wechsel einer Messprobe bei in der Bohrung verbleibendem NMR-Probenkopf möglich ist, was im Allgemeinen bevorzugt ist.

Ebenso von der vorliegenden Erfindung wird umfasst eine Verwendung einer erfindungsgemäßen, oben beschriebenen NMR-Messanordnung mit Trockengas-Spüleinrichtung, die dadurch gekennzeichnet ist, dass der NMR-Probenkopf an der NMR-Messanordnung gewechselt wird, wobei ein erster NMR-Probenkopf aus der Bohrung ausgeführt und ein zweiter NMR-Probenkopf zumindest teilweise in die Bohrung eingeführt wird, und währenddessen die Bohrung zumindest im Bereich des Teilstücks mit einem trockenen Gas, insbesondere trockenem Stickstoff oder trockenem Helium, mit der Trockengas-Spüleinrichtung gespült wird. Dieses Vorgehen ist schnell, einfach und kostengünstig, und minimiert eine Kondenswasserbildung am (kalten) Teilstück.

Zudem wird von der vorliegenden Erfindung umfasst eine Verwendung einer erfindungsgemäßen NMR-Messanordnung mit einer Heizeinrichtung, die dadurch gekennzeichnet ist, dass der NMR-Probenkopf an der NMR-Messanordnung gewechselt wird, wobei ein erster NMR-Probenkopf aus der Bohrung ausgeführt und ein zweiter NMR-Probenkopf zumindest teilweise in die Bohrung eingeführt wird, und währenddessen die Bohrung zumindest im Bereich des Teilstücks mit der Heizeinrichtung beheizt wird, so dass an der Wand der Bohrung eine Kondenswasserbildung vermieden wird, insbesondere wobei die Wand der Bohrung zumindest im Bereich des Teilstücks auf ihrer der Umgebung zugewandten Seite eine Temperatur von wenigstens 10°C aufweist. Dieses Vorgehen ist vergleichsweise einfach und minimiert eine Kondenswasserbildung am (im Normalbetrieb kalten) Teilstück, erfordert jedoch gewisse Wartezeiten für das Erreichen der jeweils nötigen Temperaturen am Teilstück.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden, sofern dadurch der durch die Ansprüche definierte Schutzumfang nicht verlassen wird.

Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

- Fig. 1: zeigt einen schematischen Längsschnitt durch eine beispielhafte NMR-Messanordnung nach dem Stand der Technik;
- Fig. 2: zeigt einen schematischen Längsschnitt durch eine erste Ausführungsform einer erfindungsgemäßen NMR-Messanordnung, mit einem fest in einer Bohrung installiertem NMR-Probenkopf;
- Fig. 3: zeigt einen schematischen Längsschnitt durch eine zweite Ausführungsform einer erfindungsgemäßen NMR-Messanordnung, mit einem in eine durchgehende Bohrung einschiebbaren NMR-Probenkopf, mit zwei radialen Dichtungen und Heizvorrichtung;
- Fig. 4: zeigt einen schematischen Längsschnitt durch eine dritte Ausführungsform einer erfindungsgemäßen NMR-Messanordnung, mit einem in eine einseitig geschlossene Bohrung einschiebbaren NMR-Probenkopf, mit einer Radialdichtung und einer Trockengas-Spüleinrichtung;
- Fig. 5: zeigt einen schematischen Längsschnitt durch eine vierte Ausführungsform einer erfindungsgemäßen NMR-Messanordnung, mit einem in eine einseitig geschlossene Bohrung einschiebbaren NMR-Probenkopf, mit Schleusenkammer und Pumpeinrichtung;
- Fig. 6: zeigt einen schematischen Längsschnitt durch eine fünfte Ausführungsform einer erfindungsgemäßen NMR-Messanordnung, mit einem zweistufigen Kryokühler und in einem Kryobehälter angeordneten Magnetspulensystem;
- Fig. 7: zeigt einen schematischen Längsschnitt durch eine sechste Ausführungsform einer erfindungsgemäßen NMR-Messanordnung, mit einem zweistufigen Kryokühler und einem direkt im Vakuumbehälter angeordneten Magnetspulensystem;
- Fig. 8a: zeigt eine schematische Schrägansicht eines Zentralrohrs eines Vakuumbehälters für die Erfindung, mit einer Schlitzung einer radial äußeren Beschichtung in einem mittleren Teilbereich;
- Fig. 8b: zeigt eine schematische Seitenansicht des Zentralrohrs von Fig. 8a;
- Fig. 8c: zeigt einen Querschnitt durch das Zentralrohr bei Schnittebene A-A von Fig. 8a;
- Fig. 8d: zeigt einen vergrößerten Ausschnitt aus dem Querschnitt von Fig. 8b im Bereich des Markierungskreises D.

In den Figuren sind NMR-Messanordnungen nach dem Stand der Technik und gemäß der Erfindung beispielhaft dargestellt. Die Darstellungen sind dabei grob schematisch, und insbesondere sind einige Strukturen im Vergleich zu anderen Strukturen vergrößert oder verkleinert dargestellt, um die Erfindung leichter verständlich zu machen.

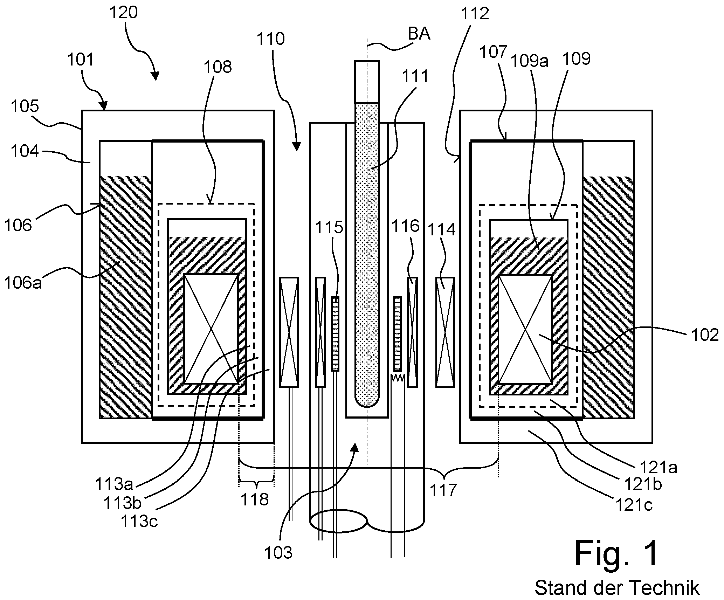

Die **Fig. 1** zeigt beispielhaft eine NMR-Messanordnung 120 nach dem Stand der Technik.

Die NMR-Messanordnung 120 verfügt über einen Kryostaten 101, ein supraleitendes Magnetspulensystem 102, welches in dem Kryostaten 101 angeordnet ist, sowie über einen NMR-Probenkopf 103.

Der Kryostat 101 hat eine zentrale, hier durchgehende Bohrung 110 entlang einer Bohrungsachse BA. In der Bohrung 110 ist der NMR-Probenkopf 103 angeordnet. Die Bohrung 110 liegt zudem radial innerhalb und koaxial zu einer Magnetbohrung 117 des Magnetspulensystems 102. In den NMR-Probenkopf 110 ist hier eine Messprobe 111 eingeschoben, an der eine NMR-Messung stattfinden kann. Weiterhin ist in der Bohrung 110 ein elektrisches Shim-Spulensystem 114 angeordnet. Der NMR-Probenkopf 103 verfügt hier über ein HF-Spulensystem 115 und ein Gradienten-Spulensystem 116.

Der Kryostat 101 verfügt in der gezeigten Bauform über einen Vakuumbehälter 105, in dessen evakuiertem Innenraum 104 ein Stickstoffbehälter 106 mit flüssigem Stickstoff (LN2) 106a angeordnet ist, welcher als Wärmesenke einen äußeren Metallblech-Strahlungsschild 107 kühlt. Der äußere Metallblech-Strahlungsschild 107 umgibt zusammen mit dem Stickstoffbehälter 106 einen inneren Metallblech-Strahlungsschild 108, der hier als "passiver" Strahlungsschild ausgebildet ist und nicht gesondert an eine Wärmesenke gekoppelt ist. Der innere Metallblech-Strahlungsschild 108 umgibt wiederum einen Kryobehälter 109, in welchem als Kryofluid flüssiges Helium (LHe) 109a enthalten ist, welches das ebenfalls in dem Kryobehälter 109 angeordnete Magnetspulensystem 102 als weitere Wärmesenke kühlt.

Die Bohrung 110 ist als eine Raumtemperaturbohrung ausgebildet, d.h. die Wand 112 der Bohrung 110, welche den Vakuumbehälter 105 bzw. dessen evakuierten Innenraum 104 mit begrenzt, hat näherungsweise Raumtemperatur. Dies wird durch eine gute thermische Isolation zwischen der Wand 112 der Bohrung 110 und dem Kryobehälter 109 erreicht, die auf hier insgesamt drei evakuierten Spalträumen 113a-113c im Zwischenraum 118 zwischen dem Magnetspulensystem 102 und der Wand 112 der Bohrung 110 beruht. In der (radialen) Abfolge von innen nach außen (gesehen von dem Magnetspulensystem 102 aus auf die Wand 112 der Bohrung 110 zu, also nach radial innen hin) ist ein erster evakuierter Spaltraum 113a zwischen dem Kryobehälter 109 und dem inneren Metallblech-Strahlungsschild 108 ausgebildet. Ein zweiter evakuierter Spaltraum 113b ist zwischen dem inneren Metallblech-Strahlungsschild 108 und dem äußeren Metallblech-Strahlungsschild 107 ausgebildet. Ein dritter evakuierter Spaltraum 113c ist zwischen dem äußeren Metallblech-Strahlungsschild 107 und der Wand 112 der Bohrung 110 (wobei die Wand 110 ein Teil des Vakuumbehälters 105 ist) ausgebildet.

Aufgrund der drei evakuierten Spalträume 113a-113c wird ein erheblicher Anteil der Magnetbohrung 117 des Magnetspulensystems 102 verbraucht und steht somit nicht für die eigentliche NMR-Messung an der Messprobe 111 zur Verfügung, und das Magnetspulensystem 102 muss einen relativ großen radialen Abstand zur Bohrung 110 einhalten. Dies erschwert die Erzeugung hoher Magnetfeldstärken und erschwert NMR-Messungen von hoher Qualität an der Messprobe 111.

Man beachte, dass in der Bauform von Fig. 1 ausgehend von dem Magnetspulensystem 102 in der Abfolge von innen nach außen zum Vakuumbehälter 105 hin nicht nur auf die Wand 12 zu, sondern auch auf andere Wandabschnitte zu in der Abfolge jeweils drei evakuierte Spalträume vorhanden sind, zum Beispiel in axialer Richtung nach unten hin die drei evakuierten Spalträume 121a, 121b, 121c.

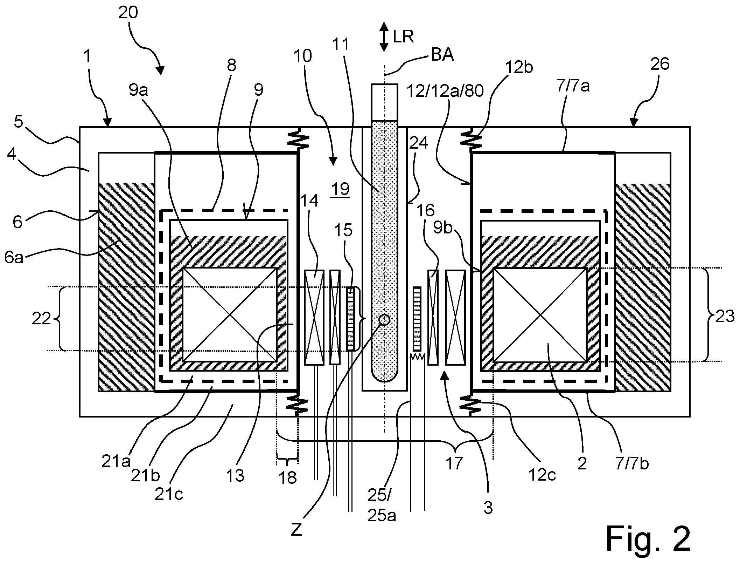

Die **Fig. 2** zeigt eine erste Ausführungsform einer erfindungsgemäßen NMR-Messanordnung 20 in einem schematischen Längsschnitt. Es werden vor allem die Unterschiede zur Bauform von Fig. 1 erläutert.

Die NMR-Messanordnung 20 verfügt über einen Kryostaten 1, ein supraleitendes Magnetspulensystem 2, welches im Kryostaten 1 angeordnet ist, und einen NMR-Probenkopf 3, der in einer zentralen, entlang einer hier vertikalen Bohrungsachse BA verlaufenden Bohrung 10 des Kryostaten 1 angeordnet ist. Die Bohrungsachse BA definiert eine Längsrichtung LR.

Die Bohrung 10 liegt radial innerhalb und koaxial zu einer Magnetbohrung 17 des Magnetspulensystems 2. Die Bohrung 10 ist hier beidseitig geschlossen mit einer von außen zugänglichen Probenausnehmung 24 ausgebildet. Das hier als Solenoid ausgeführte, im Wesentlichen zylindermantelförmige Magnetspulensystem 2 erzeugt in einem Bereich um ein magnetisches Zentrum Z herum ein homogenes statisches Magnetfeld, das parallel zur Bohrungsachse BA gerichtet ist, für eine NMR-Messung an einer Messprobe 11 in der Probenausnehmung 24.

Der Kryostat 1 verfügt über einen Vakuumbehälter 5, dessen Innenraum 4 evakuiert ist; die Wand 12 der Bohrung 10 begrenzt dabei den Vakuumbehälter 5 mit, nämlich nach radial innen hin. Die Wand 12 ist hier zylindermantelförmig ausgebildet. Die Wand 12 der Bohrung wird auch als Zentralrohr 80 bezeichnet.

In der gezeigten Ausführungsform ist im Vakuumbehälter 5 ein Stickstofftank 6 angeordnet, der mit flüssigem Stickstoff (LN2) 6a (bei ca. 77K) befüllt ist und als eine Wärmesenke dient. Mit dem Stickstofftank 6 verbunden und damit thermisch an diesen gekoppelt ist ein äußerer Metallblech-Strahlungsschild 7, welcher mit einem oberen Schildteil 7a und einem unteren Schildteil 7b ausgebildet ist. Dieses beiden Schildteile 7a, 7b sind wiederum an die Wand 12 der Bohrung 10 gekoppelt, wobei die Wand 12 den Vakuumbehälter 5 nach radial innen begrenzt. Dadurch ist auch ein mittlerer Teilbereich 12a der Wand 12 an den Stickstofftank 6 thermisch gekoppelt. Der mittlere Teilbereich 12a der Wand 12 ist dadurch gekühlt.

Im Vakuumbehälter 5 ist in der gezeigten Ausführungsform weiterhin ein Kryobehälter 9 angeordnet, in welchem als Kryofluid flüssiges Helium (LHe) 6a (bei ca. 4,2 K oder noch kälter) angeordnet ist, und der als weitere Wärmesenke dient. Innerhalb dieses Kryobehälters 9 ist auch das supraleitende Magnetspulensystem 2 angeordnet und dadurch gekühlt. Der Kryobehälter 9 ist mit Ausnahme der nach radial innen liegenden Seite allseits von einem inneren Metallblech-Strahlungsschild 8 umgeben. Der innere Metallblech-Strahlungsschild 8 ist wiederum nach radial außen hin vom Stickstofftank 6 und nach axial oben und axial unten vom äußeren Metallblech-Strahlungsschild 7 bzw. den Schildteilen 7a, 7b umgeben.

Jedoch liegt der radial innen liegenden Wand 9b des Kryobehälters 9 die Wand 12 der Bohrung 10 direkt gegenüber, getrennt nur durch einen einzigen evakuierten Spaltraum 13. Damit liegt im Zwischenraum 18 zwischen dem Magnetspulensystem 2 und der Wand 12 der Bohrung 10 in (radialer) Abfolge von innen nach außen (vom Magnetspulensystem 2 auf die Wand 12 der Bohrung 10 zu, also nach radial innen hin) insgesamt lediglich ein einziger evakuierter Spaltraum 13. Insbesondere sind in diesem Zwischenraum 18 keine Metallblech-Strahlungsschilde angeordnet; die beiden Metallblech-Strahlungsschilde 7 und 8 sind im Bereich dieses Zwischenraums 18 unterbrochen.

Durch den einzigen Spaltraum 13 wird lediglich ein kleiner Anteil der Magnetbohrung 17 des Magnetspulensystems 2 verbraucht, und das Magnetspulensystem 2 kann relativ nahe an die Bohrung 10 bzw. die Wand 12 heranrücken. Dadurch steht in der Magnetbohrung 17 relativ viel Raum für die eigentliche NMR-Messung an der Messprobe 11 und insbesondere für die Messprobe 11 selbst zur Verfügung, und es können NMR-Messungen von hoher Qualität an der Messprobe 11 in der Bohrung 10 durchgeführt werden.

Man beachte, dass in der Ausführungsform von Fig. 2 ausgehend von dem Magnetspulensystem 2 in der Abfolge von innen nach außen zum Vakuumbehälter 5 auf andere Wandabschnitte des Vakuumbehälters 5 als die Wand 12 zu jeweils drei evakuierte Spalträume vorhanden sind, zum Beispiel in axialer Richtung nach unten hin die drei evakuierten Spalträume 21a, 21b, 21c. Die thermische Isolation des Kryobehälters 9 bzw. des Magnetspulensystems 2 ist also nach axial oben und unten oder auch nach radial außen hin, wo der Bauraum nicht knapp ist, nicht unnötig geschwächt.

Aufgrund der Kühlung der Wand 12 bzw. von dessen mittlerem Teilbereich 12a mittels hier des Stickstofftanks 6 als Wärmesenke kann ein Wärmeeintrag in den Kryobehälter 9 und damit in das Magnetspulensystem 2 auf ein akzeptables Maß begrenzt werden, obwohl auf der Seite des Kryobehälters 9 nach radial innen (vor der Wand 9b) nur ein evakuierter Spaltraum 13 zur thermischen Isolation zur Verfügung steht. Insbesondere bleibt es möglich, den Kryobehälter 9 auf einer gewünschten Temperatur (meist 4,2 K oder weniger) bei akzeptablen Betriebskosten zu halten.

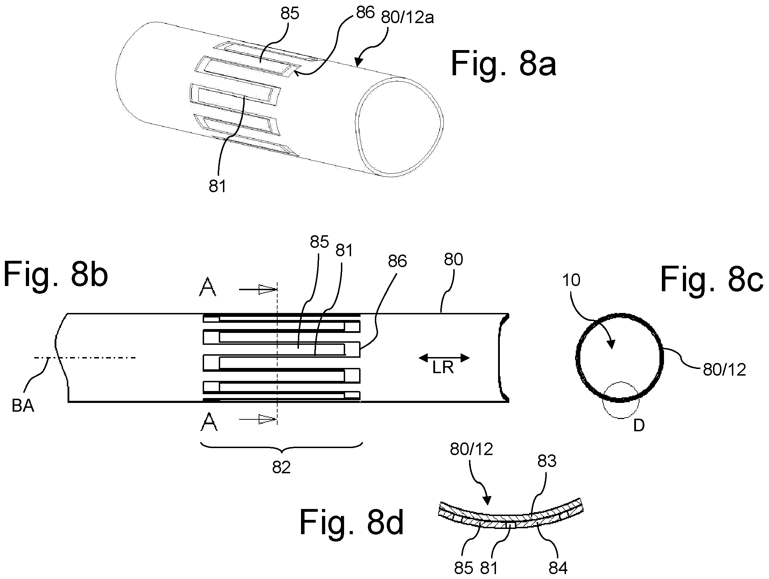

Die Wand 12 der Bohrung 10 ist mehrteilig ausgebildet und umfasst hier den mittleren Teilbereich 12a und zwei axial äußere Teilbereiche 12b, 12c. Die Ankopplung des äußeren Metallblech-Strahlungsschilds 7 erfolgt nahe den axial äußeren Enden des mittleren Teilbereichs 12a. Die äußeren Teilbereiche 12b, 12c bilden hier also den Übergang vom mittleren Teilbereich 12a (begrenzt durch die Ankoppelstellen des äußeren Metallblech-Strahlungsschilds 7) zum übrigen Vakuumbehälter 5 (der auch als Raumtemperatur-Mantel 26 bezeichnet werden kann). Die äußeren Teilbereiche 12b, 12c dienen zur thermischen Entkopplung des mittleren Teilbereichs 12a vom übrigen Vakuumbehälter 5 bzw. dessen übriger (entfernt von der Bohrung 10 befindlicher) äußerer Wand, also vom Raumtemperatur-Mantel 26. Die äußeren Teilbereiche 12b, 12c sind hier als Faltenbälge ausgebildet und verfügen über eine im Vergleich zum mittleren Teilbereich 12a der Wand 12 (und bevorzugt auch im Vergleich zur übrigen äußeren Wand des Vakuumbehälters 5 bzw. dem Raumtemperatur-Mantel 26) über eine verminderte Wärmeleitfähigkeit und/oder eine verminderte Wandstärke. Beispielsweise kann der mittlere Teilbereich 12a als ein Stahlrohr mit einer Kupferbeschichtung ausgebildet sein (in Fig. 2 nicht näher dargestellt, vgl. aber Fig. 8a-8d hierzu), und die äußeren Teilbereiche 12b, 12c sind aus Stahl mit einer dünneren Wandstärke ohne Kupferbeschichtung ausgebildet.

In der gezeigten Ausführungsform ist der Bohrung 10 oben und unten gasdicht geschlossen ausgebildet, wodurch ein hermetisch abgedichteter Raum 19 in der Bohrung 10 ausgebildet ist. Der abgedichtete Raum 19 liegt insbesondere außerhalb des Vakuumbehälters 5 bzw. von dessen evakuiertem Innenraum 4. Die Wand 12 der Bohrung 10 begrenzt den abgedichteten Raum 19 mit. In der Bohrung 10 in diesem abgedichteten (abgeschlossenen) Raum 19 ist der NMR-Probenkopf 3, hier umfassend ein HF-Spulensystem 15, ein Gradienten-Spulensystem 16 und ein elektrisches Shim-Spulensystem 14, dauerhaft angeordnet. Nach radial innen wird der abgedichtete Raum 19 durch die Probenausnehmung 24 begrenzt. In der Probenausnehmung 24 ist die Messprobe 11 (hier ein mit einer Probenflüssigkeit gefülltes Röhrchen) unter Umgebungsdruck angeordnet.

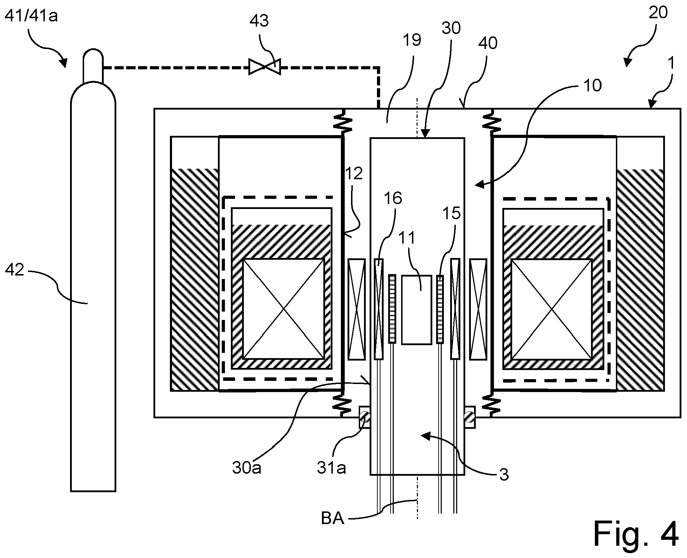

Der abgedichtete Raum 19 ist mit einem Trockengas befüllt, beispielsweise trockenem Stickstoff. Die Befüllung mit Trockengas kann über eine in Fig. 2 nicht näher dargestellte Trockengas-Befüllungseinrichtung erfolgen (entsprechend der Trockengas-Befüllungseinrichtung 41a in Fig. 4). Durch das Trockengas werden der NMR-Probenkopf 3 bzw. dessen im abgedichteten Raum 19 angeordnete Komponenten (hier das HF-Spulensystem 15, das Gradienten-Spulensystem 16 und das Shim-Spulensystem 14) thermisch mit der Wand 12 gekoppelt und dadurch gekühlt, wodurch das Signal-zu-Rausch-Verhältnis der NMR-Messungen an der Messprobe 11 verbessert werden kann. Im abgedichteten Raum 19 können Vorrichtungen zur Verringerung von Konvektion im Trockengas vorgesehen sein, insbesondere so genannte "Baffles" (nicht näher dargestellt); dadurch kann insbesondere ein axialer konvektiver Wärmefluss klein gehalten werden. Alternativ oder zusätzlich kann auch eine Kopplung von Komponenten des NMR-Probenkopfs 3, insbesondere des Shim-Spulensystems 14, über eine gut wärmeleitende Festkörperverbindung, etwa aus Kupfer, zur Wand 12 erfolgen (nicht näher dargestellt).

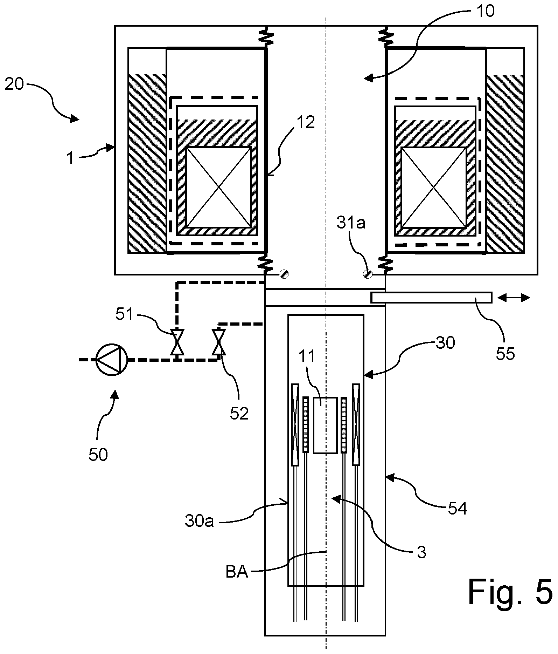

Alternativ kann der abgedichtete Raum 19 im Normalbetrieb mit einer nicht näher dargestellten Pumpeinrichtung evakuiert werden (entsprechend der Pumpeinrichtung 50 von Fig. 5), was eine thermische Isolation der Komponenten des NMR-Probenkopfs 3 verbessert.

Weiterhin ist in der gezeigten Ausführungsform eine eigene Kühlvorrichtung 25 für das HF-Spulensystem 15 im NMR-Probenkopf 3 vorgesehen. Die eigene Kühlvorrichtung 25 umfasst eine Kühlleitung 25a, mit der ein kaltes Fluid (meist Helium) zum HF-Spulensystem 15 geleitet wird (typischerweise unter einem Druck von mehreren bar), wodurch dieses (zusätzlich zur Kopplung über das Trockengas an die Wand 12, oder falls der abgedichtete Raum 19 evakuiert ist durch die eigene Kühlvorrichtung 25 allein) auf eine gewünschte Messtemperatur abgekühlt wird. Das Fluid zykliert in der Kühlleitung 25a, d.h. am HF-Spulensystem 15 erwärmtes Fluid fließt aus dem NMR-Probenkopf 3 zurück und wird in nicht näher dargestellter Weise außerhalb des NMR-Probenkopfes 3 wieder abgekühlt und dann wieder dem NMR-Probenkopf 3 zugeleitet. Im Falle eines Lecks in der Kühlleitung 25 erfolgt ein Austritt des Fluids lediglich in die Bohrung 10 bzw. den abgedichteten Raum 19, nicht aber in den evakuierten Innenraum 4 des Vakuumbehälters 5; somit besteht durch ein solches Leck keine Gefahr eines Quenchs des Magnetspulensystems 2.

In der gezeigten Variante ist die Wand 12 über fast die gesamte axiale Länge der Wand 12 der Bohrung 10 mit der Wärmesenke, die durch den Stickstofftank 6 gebildet wird, thermisch gekoppelt. Man beachte, dass in anderen Ausführungsformen lediglich ein Teilstück der Wand 12 mit einer axialen Länge entsprechend dem aktiven Bereich 22 des HF-Spulensystems 15 oder entsprechend der axialen Länge 23 des Magnetspulensystems 2 an die Wärmesenke gekoppelt sein kann (nicht näher dargestellt).

Man beachte, dass zur Aufrechterhaltung der Kühlung des Magnetspulensystems 2 der flüssige Stickstoff 6a und das flüssige Helium 9a bei Bedarf nachgefüllt werden können, und/oder mittels einem oder mehreren Kryokühlern (nicht näher dargestellt) der Stickstoffbehälter 6 und/oder der Kryobehälter 9 aktiv gekühlt werden können. Der Stickstofftank 6 und der Kryobehälter 9 verfügen über Leitungen, die das Entweichen von verdampften Kryogenen (Helium, Stickstoff) ermöglichen (nicht näher dargestellt).

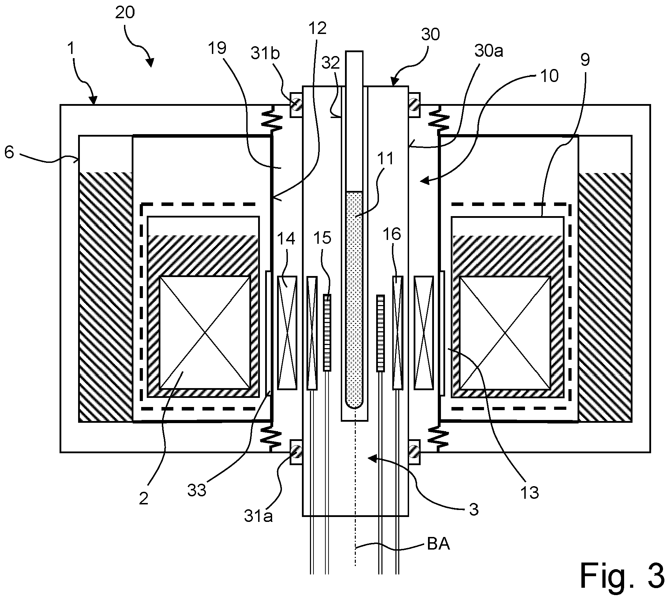

Die **Fig. 3** zeigt eine zweite Ausführungsform einer erfindungsgemäßen Messanordnung 20 ähnlich der Ausführungsform von Fig. 2, so dass nachfolgend nur die wesentlichen Unterschiede erläutert werden.

In der Ausführungsform von Fig. 3 ist der Kryostat 1 mit einer durchgehenden Bohrung 10 ausgebildet. Der NMR-Probenkopf 3 ist mit einem Gehäuse 30 aufweisend eine radial äußere, gasdichte Gehäusewand 30a ausgebildet, wobei innerhalb des Gehäuses 30 das HF-Spulensystem 15 und hier auch das Gradienten-Spulensystem 16 angeordnet sind. Bevorzugt ist das Gehäuse 30 insgesamt gasdicht ausgebildet, so dass es beispielsweise zur thermischen Isolation evakuierbar ist. Durch die Wand 12 der Bohrung 10, die gasdichte Gehäusewand 30a und zwei Radialdichtungen 31a, 31b, hier umlaufenden Gummiringen, wird der abgedichtete Raum 19 begrenzt; die Bohrung 10 wird entsprechend an ihren beiden axialen Enden (Öffnungen) durch den NMR-Probenkopf 3 im Normalbetrieb verschlossen. Der NMR-Probenkopf 3 bzw. dessen Gehäuse 30 bildet eine Probenausnehmung 32 für die Messprobe 11 aus, die in der Probenausnehmung 32 unter Umgebungsdruck angeordnet ist. Dadurch, dass der NMR-Probenkopf 3 mit seinem vorderen (hier oberen) Ende durch die Bohrung 10 hindurchragt (also auch vorne bzw. oben wieder aus der Bohrung 10 herausragt), ist die Probenausnehmung 32 ist für einen Wechsel der Messprobe 11 (hier von oben) von der Umgebung aus direkt zugänglich, insbesondere ohne dass der NMR-Probenkopf 3 aus der Bohrung 10 entfernt (ausgebaut) werden müsste. Entsprechend ist ein Probenwechsel sehr einfach und schnell möglich.

Um den NMR-Probenkopf 3 zu wechseln, etwa im Falle eines Defekts oder für eine Wartung, kann der NMR-Probenkopf 3 in axialer Richtung (hier nach unten), entlang der Bohrungsachse BA, aus der Bohrung 10 herausgezogen werden und durch einen anderen NMR-Probenkopf 3 ersetzt werden, der in axialer Richtung (hier nach oben) in die Bohrung 10 eingeschoben wird.

Dadurch wird die Bohrung 10 zeitweise an beiden Enden geöffnet und den atmosphärischen Bedingungen der Umgebung ausgesetzt. Um in dieser Zeit eine Kondenswasserbildung und Vereisung der durch den Stickstofftank 6 gekühlten Wand 12 der Bohrung 10 zu verhindern, wird eine elektrische Heizeinrichtung 33 aktiviert, die hier an der radial äußeren Seite der Wand 12 ausgebildet ist. Mit der Heizeinrichtung 33 wird die die Wand 12 auf wenigstens 10°C aufheizt; die dadurch entstehende Wärmelast auf den Stickstofftank 6 und auch auf den Kryobehälter 9 ist für die kurze Zeit der Dauer eines Probenkopfwechsels hinnehmbar, ohne dass ein Quench im supraleitenden Magnetspulensystem 2 oder merkliche zusätzliche Betriebskosten befürchtet werden müssten.

Das Volumen des abgedichteten Raums 19 ist relativ klein, so dass in diesem Volumen enthaltene Luftfeuchtigkeit keine merkliche Kondenswasserbildung im Normalbetrieb (mit abgeschalteter Heizeinrichtung) verursacht; durch die Abdichtung mit den Radialdichtungen 31a, 31b ist ein Luftaustausch mit der Umgebung und damit der Eintrag weiterer Feuchtigkeit ausgeschlossen. Zusätzlich kann vorgesehen sein, den abgedichteten Gasraum 19 für den Normalbetrieb zu evakuieren oder mit einem Trockengas zu befüllen (vgl. hierzu Fig. 4 oder 5), um auch kleinste Mengen von Kondenswasser auszuschließen.

Anstatt oder zusätzlich zur Aktivierung der Heizeinrichtung 33 ist es möglich, die Bohrung 10 während des Probenkopfwechsels mit Trockengas zu spülen (vgl. Fig. 4 hierzu).

Es ist auch möglich, - jedoch nicht näher gezeigt - den NMR-Probenkopf geteilt auszuführen, und einen Teil (z.B. einen elektrisch aktiven Teil mit HF-Spulensystem, Shims-Spulensystem und Gradienten-Spulensystem) von einer Seite (üblicherweise unten) einzuführen, und einen anderen Teil (z.B. einen Teil, der die Einrichtungen für die Probenzufuhr und -rotation beinhaltet) von einer anderer Seite (üblicherweise von oben) in die Bohrung einzuführen.

Die **Fig. 4** zeigt eine dritte Ausführungsform einer erfindungsgemäßen Messanordnung 20 ähnlich der Ausführungsform von Fig. 2, so dass nachfolgend nur die wesentlichen Unterschiede erläutert werden.

In der Ausführungsform von Fig. 4 ist der Kryostat 1 mit einer einseitig (unten) offenen Bohrung 10 ausgebildet; an der Oberseite der Bohrung 10 ist diese hier mit einer Abdeckung 40 verschlossen. Der NMR-Probenkopf 3 ist mit einem Gehäuse 30 mit gasdichten Gehäusewänden 30a ausgebildet, innerhalb dessen das HF-Spulensystem 15 und hier auch das Gradienten-Spulensystem 16 angeordnet sind. Durch die Wand 12 der Bohrung 10, die gasdichte Gehäusewand 30a und eine Radialdichtung 31a im Bereich der unteren Öffnung der Bohrung 10 wird der abgedichtete Raum 19 begrenzt; der NMR-Probenkopf 3 verschließt somit im Normalbetrieb die untere Öffnung der Bohrung 10. Der NMR-Probenkopf 3 enthält hier auch die eingebaute Messprobe 11.

Um den NMR-Probenkopf 3 zu wechseln, insbesondere für einen Austausch der Messprobe 11, kann der NMR-Probenkopf 3 in axialer Richtung, entlang der Bohrungsachse BA, nach unten aus der Bohrung 10 herausgezogen werden und durch einen anderen NMR-Probenkopf 3 enthaltend eine andere Messprobe 11 ersetzt werden, der in axialer Richtung in die Bohrung 10 von unten eingeschoben wird. Dadurch wird die Bohrung 10 zeitweise an ihrem unteren Ende geöffnet und den atmosphärischen Bedingungen der Umgebung ausgesetzt. Um in dieser Zeit eine Kondenswasserbildung und Vereisung der durch den Stickstofftank 6 gekühlten Wand 12 der Bohrung 10 zu verhindern, wird eine Trockengas-Spüleinrichtung 41 aktiviert, die hier von der Abdeckung 40 her die Bohrung 10 mit einem Trockengas, beispielsweise trockenem Stickstoff, spült. Dabei wird ständig Trockengas nach unten aus der Bohrung 10 gedrängt, so dass keine merkliche Einströmung von (feuchter) Umgebungsluft in die Bohrung 10 erfolgen kann.

Die Trockengas-Spüleinrichtung 41 umfasst hier eine Druckgasflasche 42 mit Trockengas und ein Steuerventil 43 in einer von der Druckgasflasche 42 zur Abdeckung 40 führenden Gasleitung.

Die dargestellte Trockengas-Spüleinrichtung 41 kann auch als eine Trockengas-Befüllungseinrichtung 41a eingesetzt werden, um nach einem Probenkopfwechsel den abgedichteten Raum 19 mit Trockengas zu befüllen. Hierfür kann der abgedichtete Raum 19 zunächst mit einer Pumpvorrichtung (nicht dargestellt, vgl. aber Fig. 5 hierzu) evakuiert werden, oder zunächst enthaltene Luft im abgedichteten Raum 19 wird durch einströmendes Trockengas über ein Auslassventil oder Überdruckventil (nicht näher dargestellt) aus dem abgedichteten Raum 19 herausgedrängt.

Die **Fig. 5** zeigt eine dritte Ausführungsform einer erfindungsgemäßen Messanordnung ähnlich der Ausführungsform von Fig. 4, so dass nachfolgend nur die wesentlichen Unterschiede erläutert werden.

Die NMR-Messanordnung 20 dieser Ausführungsform verfügt wiederum über einen Kryostaten 1 mit einer einseitig (nach unten hin) offenen Bohrung 10, in die der NMR-Probenkopf 3 wie in Fig. 4 erläutert axial nach oben eingeschoben werden kann und aus der der NMR-Probenkopf 3 axial nach unten herausgezogen werden kann, wobei im eingeschobenen Zustand der in Fig. 4 gezeigte abgedichtete Raum (dort Bzz. 19) durch die Wand 12 der Bohrung 10, die gasdichte Gehäusewand 30a und die Radialdichtung 31a begrenzt wird.

In der Ausführungsform von Fig. 5 ist am unteren Ende (an der unteren Öffnung) der Bohrung 10 eine Schleusenkammer 54 angeordnet. Das Innere der Bohrung 10 und das Innere der Schleusenkammer 54 können mit einem Schieberventil 55 vakuumdicht voneinander abgetrennt werden. Eine Pumpeinrichtung 50 kann über Steuerventile 51 und 52 und zugehörige Pumpleitungen die Bohrung 10 und die Schleusenkammer 54 unabhängig voneinander evakuieren. Die Bohrung 10 wird in dieser Ausführungsform stets unter Vakuum gehalten, um eine Kondenswasserbildung an der kalten Wand 12 der Bohrung 10 zu verhindern.

Die Fig. 5 zeigt die NMR-Messanordnung 20 in einem Zustand mit in die Schleusenkammer 54 zurückgezogenem NMR-Probenkopf 3. Sind die Bohrung 10 und die Schleusenkammer 54 mittels der Pumpeinrichtung 50 evakuiert, kann der NMR-Probenkopf 3 bei geöffnetem Schieberventil 55 zwischen der Bohrung 10 und der Schleusenkammer 54 verfahren werden.

Für eine Manipulation am NMR-Probenkopf 3, etwa für einen Austausch der in den Probenkopf 3 eingebauten Messprobe 11, oder auch für einen vollständigen Austausch des NMR-Probenkopfs 3, kann der Probenkopf 3 in die Schleusenkammer 54 zurückgezogen werden, und die Bohrung 10 mit dem Schieberventil 55 verschlossen werden. Sodann kann die Schleusenkammer 54 über eine nicht näher dargestellte Tür eröffnet werden, um gewünschte Manipulationen am NMR-Probenkopf 3 durchzuführen, etwa die Messprobe 11 auszutauschen; falls erforderlich, kann der NMR-Probenkopf 3 für die Manipulation auch aus der Schleusenkammer 54 entfernt werden. Alternativ kann die Schleusenkammer 54 auch vom Kryostaten 1 abmontiert werden (das Schieberventil 55 verbleibt dabei am Kryostaten 1); der NMR-Probenkopf 3 kann dann durch die stirnseitige Öffnung (am Anschluss für das Schieberventil 55) der Schleusenkammer 54 entnommen werden.

Sind die Manipulationen beendet, wird bei in der Schleusenkammer 54 angeordnetem NMR-Probenkopf 3 die nicht näher dargestellte Tür der Schleusenkammer 54 wieder geschlossen bzw. die Schleusenkammer 54 wieder am Kryostaten 1 montiert und die Schleusenkammer 54 (bei geöffnetem Steuerventil 52) evakuiert. Sodann kann das Schieberventil 55 geöffnet werden, und der NMR-Probenkopf 3 kann von der Schleusenkammer 54 in die Bohrung 10 eingeschoben werden.

In der gezeigten Ausführungsform ist der NMR-Probenkopf 3 so lang, dass im in die Bohrung 10 eingeschobenen Zustand des Normalbetriebs das Schieberventil 55 nicht geschlossen werden kann. Aufgrund der Abdichtung des abgedichteten Raums (Bzz. 19 in Fig. 4) mittels der Radialdichtung 31a ist es jedoch nicht nötig, im Normalbetrieb die Schleusenkammer 54 auf Vakuum zu halten.

In einer Variante (nicht dargestellt) der Ausführungsform von Fig. 5 ist die Bohrung 10 durchgehend ausgebildet, mit zwei Radialdichtungen an der oberen und unteren Öffnung der Bohrung, und mit einer von oben zugänglichen Probenausnehmung im Probenkopf (vgl. Fig. 3 hierzu). Vor der unteren Öffnung der Bohrung ist die Schleusenkammer ausgebildet, und vor der oberen Öffnung ist eine weitere Schleusenkammer ausgebildet. Über die weitere Schleusenkammer ist die Probenausnehmung für einen Probenwechsel zugänglich, ohne dass das Vakuum im abgedichteten Raum zwischen der Wand der Bohrung, den beiden Radialdichtungen und der Gehäusewand des NMR-Probenkopfs gebrochen werden müsste.

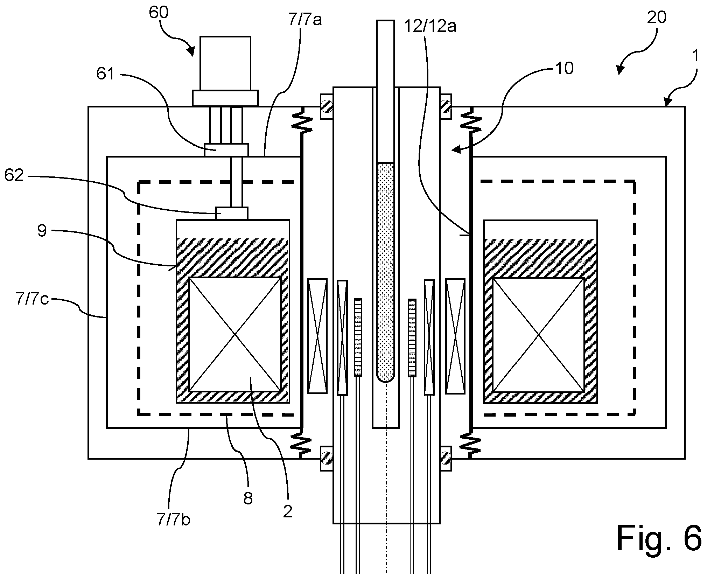

Die **Fig. 6** zeigt eine fünfte Ausführungsform einer erfindungsgemäßen NMR-Messanordnung 20 ähnlich der Ausführungsform von Fig. 3, so dass nachfolgend nur die wesentlichen Unterschiede erläutert werden.

Bei dieser Ausführungsform ist im Kryostat 1 kein Stickstofftank 6 als Wärmesenke für die Wand 12 der Bohrung 10 vorgesehen, sondern eine wärmere (hier wärmste) Kühlstufe 61 eines Kryokühlers 60, hier eines Pulsrohrkühlers. Diese wärmere Kühlstufe 61 ist an den äußeren Metallblech-Strahlungsschild 7 thermisch gekoppelt, hier durch direkte Anlage auf dem oberen Schildteil 7a. Der äußere Metallblech-Strahlungsschild 7 verfügt hier neben dem oberen Schildteil 7a und dem unteren Schildteil 7b auch über ein radial äußeres Schildteil 7c. Der äußere Metallblech-Strahlungsschild 7 umgibt allseits außer an der radial inneren Seite den inneren Metallblech-Strahlungsschild 8 und damit auch den Kryotank 9 und das darin enthaltene Magnetspulensystem 2. Der obere Schildteil 7a und der untere Schildteil 7b sind wiederum mit der Wand 12 verbunden und damit an diese thermisch gekoppelt, so dass die Wand 12 mit ihrem mittleren Teilbereich 12a an die wärmere Kühlstufe 61 des Kryokühlers 60 gekoppelt ist.

Der Kryokühler 60 verfügt weiterhin über eine kältere (hier kälteste) Kühlstufe 62, die an den Kryotank 9 (und das darin enthaltene Magnetspulensystem 2) als weitere Wärmesenke thermisch gekoppelt ist, hier durch eine direkte Anlage.

Die NMR-Messanordnung 20 kann wie oben beschrieben zusätzlich beispielsweise mit einer Heizeinrichtung oder einer Trockengas-Spüleinrichtung versehen sein (nicht näher dargestellt in Fig. 6), um Kondenswasserbildung an der Wand 12 der Bohrung 10 bei einem Probenkopfwechsel zu vermeiden.

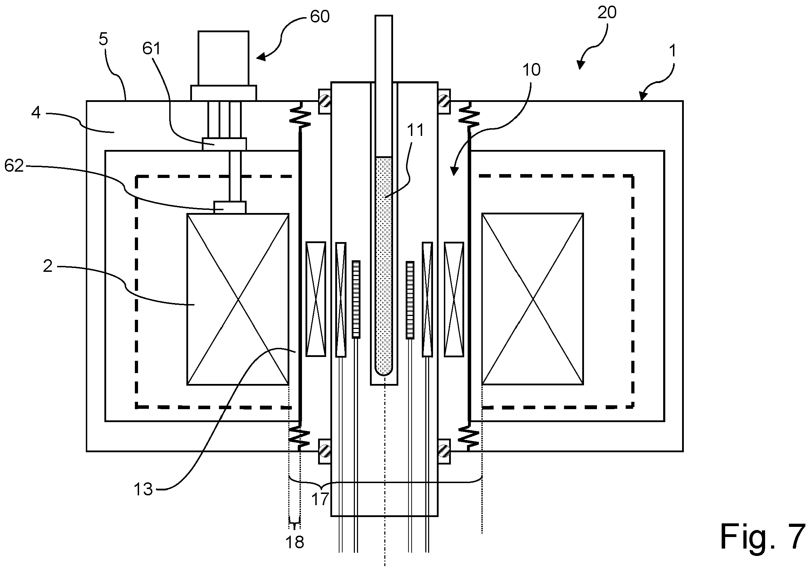

Die **Fig. 7** zeigt eine sechste Ausführungsform einer erfindungsgemäßen NMR-Messanordnung 20 ähnlich der Ausführungsform von Fig. 6, so dass nachfolgend nur die wesentlichen Unterschiede erläutert werden.

Bei dieser Ausführungsform ist das supraleitende Magnetspulensystem 2 nicht in einem Kryobehälter mit flüssigem Helium, sondern direkt im evakuierten Innenraum 4 des Vakuumbehälters 5 angeordnet und somit dem Isolationsvakuum ausgesetzt. Das Magnetspulensystem 2 ist an die kältere Kühlstufe 62 des Kryokühlers 60 thermisch gekoppelt, hier durch direkte Anlage der kälteren Kühlstufe 62 auf dem Magnetspulensystem 2.

Der Zwischenraum 18 radial zwischen dem Magnetspulensystem 2 und der Wand 12 der Bohrung 10 wird hier vollständig von dem (einzigen) evakuierten Spaltraum 13 eingenommen. Bei dieser Ausführungsform kann das Magnetspulensystem 2 besonders nahe an die Bohrung 10 heranrücken, und ein besonders großer Anteil der Magnetbohrung 17 kann für die eigentliche NMR-Messung und insbesondere für die Messprobe 11 selbst genutzt werden.

Die **Figuren 8a-8d** erläutern schematisch den Aufbau einer beispielhaften Ausführungsform eines Zentralrohrs 80 eines Vakuumbehälters eines Kryostaten für eine erfindungsgemäßen NMR-Messanordnung. Das Zentralrohr 80 bildet im Wesentlichen den mittleren Teilbereich 12a der Wand 12 der Bohrung 10 aus, die radial im Inneren des Zentralrohrs 80 liegt. Fig. 8a zeigt dabei eine Schrägansicht, die Fig. 8b eine Seitenansicht, die Fig. 8c einen Schnitt in der Ebene A-A der Fig. 8b, und Fig. 8d ein Detail entsprechend Markierungskreis D in Fig. 8c.

Das Zentralrohr 80 besteht hier im Wesentlichen aus einem radial innen liegenden Stahlrohr als Grundstruktur 83, auf welcher radial außen liegend eine Beschichtung 84 aus Kupfer aufgebracht ist. Das Kupfer der Beschichtung 84 weist eine höhere spezifische Wärmeleitfähigkeit auf als der Stahl (bevorzugt Edelstahl) des Stahlrohrs der Grundstruktur 83.

In einem Bereich 82 um das magnetische Zentrum des Magnetspulensystems herum (vgl. Bzz. Z in Fig. 2) ist die Beschichtung 84 mit in Längsrichtung LR (entlang der Bohrungsachse BA) verlaufenden Unterbrechungen (Schlitzen) 81 versehen. In der gezeigten Ausführungsform bildet die Beschichtung 84 in Umfangsrichtung alternierend von beiden axialen Seiten vorspringende axiale Finger 85 und axiale Rücksprünge 86 aus, die ineinander greifen.

Durch die axialen Unterbrechungen 81 werden in Umfangsrichtung verlaufende elektrische Kreisströme im Bereich 82 verhindert.

### Bezugszeichenliste

- 1: Kryostat
- 2: supraleitendes Magnetspulensystem
- 3: NMR-Probenkopf
- 4: Innenraum
- 5: Vakuumbehälter
- 6: Stickstofftank
- 6a: flüssiger Stickstoff
- 7: äußerer Metallblech-Strahlungsschild
- 7a: oberer Schildteil
- 7b: unterer Schildteil
- 7c: radial äußerer Schildteil
- 8: innerer Metallblech-Strahlungsschild
- 9: Kryobehälter
- 9a: flüssiges Helium
- 9b: radial innere Wand des Kryobehälters
- 10: Bohrung (des Kryostaten)
- 11: Messprobe
- 12: Wand der Bohrung
- 12a: mittlerer Teilbereich der Wand der Bohrung
- 12b: äußerer Teilbereich der Wand der Bohrung
- 12c: äußerer Teilbereich der Wand der Bohrung
- 13: evakuierter Spaltraum (im Zwischenraum Magnetspulensystem/Wand der Bohrung)
- 14: Shim-Spulensystem
- 15: HF-Spulensystem
- 16: Gradienten-Spulensystem
- 17: Magnetbohrung
- 18: Zwischenraum (Magnetspulensystem/Wand der Bohrung)
- 19: abgedichteter Raum
- 20: NMR-Messanordnung
- 21a: evakuierter Spaltraum
- 21b: evakuierter Spaltraum
- 21c: evakuierter Spaltraum
- 22: aktiver Bereich des HF-Spulensystems
- 23: axiale Länge des Magnetspulensystems
- 24: Probenausnehmung (der Bohrung)
- 25: eigene Kühlvorrichtung
- 25a: Kühlleitung
- 26: Raumtemperatur-Mantel/übriger Teil des Vakuumbehälters
- 30: Gehäuse (des Probenkopfs)
- 30a: gasdichte Gehäusewand
- 31a: (untere) Radialdichtung
- 31b: (obere) Radialdichtung
- 32: Probenausnehmung (des NMR-Probenkopfs)
- 33: Heizeinrichtung
- 40: Abdeckung
- 41: Trockengas-Spüleinrichtung
- 41a: Trockengas-Befüllungseinrichtung
- 42: Druckgasflasche
- 43: Steuerventil
- 50: Pumpeinrichtung
- 51: Steuerventil
- 52: Steuerventil
- 54: Schleusenkammer
- 55: Schieberventil
- 60: Kryokühler
- 61: wärmere Kühlstufe
- 62: kältere Kühlstufe
- 80: Zentralrohr
- 81: Unterbrechung
- 82: Bereich um das magnetische Zentrum
- 83: Grundstruktur
- 84: Beschichtung
- 85: Finger
- 86: Rücksprung
- 100: Kryostat
- 102: supraleitendes Magnetspulensystem
- 103: NMR-Probenkopf
- 104: Innenraum
- 105: Vakuumbehälter
- 106: Stickstofftank
- 106a: flüssiger Stickstoff
- 107: äußerer Metallblech-Strahlungsschild
- 108: innerer Metallblech-Strahlungsschild
- 109: Kryobehälter
- 109a: flüssiges Helium
- 110: Bohrung (des Kryostaten)
- 111: Messprobe
- 112: Wand der Bohrung
- 113a: evakuierter Spaltraum (im Zwischenraum Magnetspulensystem/Wand der Bohrung)
- 113b: evakuierter Spaltraum (im Zwischenraum Magnetspulensystem/Wand der Bohrung)
- 113c: evakuierter Spaltraum (im Zwischenraum Magnetspulensystem/Wand der Bohrung)
- 114: Shim-Spulensystem
- 115: HF-Spulensystem
- 116: Gradienten-Spulensystem
- 117: Magnetbohrung
- 118: Zwischenraum (Magnetspulensystem/Wand der Bohrung)
- 120: NMR-Messanordnung
- 121a: evakuierter Spaltraum
- 121b: evakuierter Spaltraum
- 121c: evakuierter Spaltraum
- BA: Bohrungsachse
- LR: Längsrichtung
- Z: magnetisches Zentrum

## Patentansprüche

1. NMR-Messanordnung (20), umfassend
- einen Kryostaten (1), mit einem evakuierten Vakuumbehälter (5), wobei der Kryostat (1) eine Bohrung (10) ausbildet, und wobei eine Wand (12) der Bohrung (10) den Vakuumbehälter (5) mit begrenzt,
- ein supraleitendes Magnetspulensystem (2), mit einer Magnetbohrung (17), wobei das Magnetspulensystem (2) direkt oder indirekt innen im Vakuumbehälter (5) angeordnet ist, wobei der Kryostat (1) zur thermischen Isolation des Magnetspulensystems (2) zwischen dem supraleitenden Magnetspulensystem (2) und dem Vakuumbehälter (5) in Abfolge von innen nach außen lokal einen oder mehrere evakuierte Spalträume (13, 21a-21c) ausbildet, und wobei die Bohrung (10) durch die Magnetbohrung (17) hindurch verläuft,
- einen NMR-Probenkopf (3), mit einem HF-Spulensystem (15), wobei der NMR-Probenkopf (3) außerhalb des Vakuumbehälters (5) angeordnet ist, und wobei der NMR-Probenkopf (3) zumindest teilweise in der Bohrung (10) angeordnet ist,
wobei der Kryostat (1) im Zwischenraum (18) zwischen dem Magnetspulensystem (2) und der Wand (12) der Bohrung (10) in Abfolge von innen nach außen, ausgehend vom Magnetspulensystem (2) auf den Vakuumbehälter (5) zu, lediglich einen evakuierten Spaltraum (13) ausbildet,
wobei zumindest ein Teilstück der Wand (12) der Bohrung (10) an eine Wärmesenke des Kryostaten (1) thermisch gekoppelt ist, und
wobei die Wand (12) der Bohrung (10) einen hermetisch abgedichteten Raum (19) außerhalb des Vakuumbehälters (5) mit begrenzt, wobei sich dieser abgedichtete Raum (19) in der Bohrung (10) in Längsrichtung (LR) zumindest über die Länge des Teilstücks erstreckt.

2. NMR-Messanordnung (20) nach Anspruch 1, **dadurch gekennzeichnet, dass** die Wand (12) der Bohrung (10) und eine Gehäusewand (30a) des NMR-Probenkopfs (3) mit einer oder mehreren Dichtungen, insbesondere Radialdichtungen (31a-31b), gegeneinander abgedichtet sind.

3. NMR-Messanordnung (20) nach Anspruch 1 oder 2, **dadurch gekennzeichnet, dass** an einer Öffnung der Bohrung (10) eine Schleusenkammer (54) ausgebildet ist, durch die der NMR-Probenkopf (3) zur zumindest teilweisen Anordnung in der Bohrung (10) einschleusbar und wieder ausschleusbar ist.

4. NMR-Messanordnung (20) nach einem der Ansprüche 1 bis 3, **dadurch gekennzeichnet, dass** eine Pumpeinrichtung (50) vorgesehen ist, mit der der abgedichtete Raum (19) evakuierbar ist.

5. NMR-Messanordnung (20) nach einem der Ansprüche 1 bis 4, **dadurch gekennzeichnet, dass** eine Trockengas-Befüllungseinrichtung (41a) vorhanden ist, mit der der abgedichtete Raum (19) mit einem Trockengas, insbesondere trockenem Stickstoff oder trockenem Helium, befüllbar ist.

6. NMR-Messanordnung (20) nach einem der vorhergehenden Ansprüche,
**dadurch gekennzeichnet, dass** der Kryostat (1) mit einer Trockengas-Spüleinrichtung (41) versehen ist, mit der die Bohrung (10) zumindest im Bereich des Teilstücks mit einem trockenen Gas, insbesondere trockenem Stickstoff oder trockenem Helium, gespült werden kann.

7. NMR-Messanordnung (20) nach einem der vorhergehenden Ansprüche,
**dadurch gekennzeichnet, dass** die Wand (12) der Bohrung (10) mit einer Heizeinrichtung (33), insbesondere einer elektrischen Heizeinrichtung, versehen ist, mit der zumindest das Teilstück der Wand (12) der Bohrung (10) aufheizbar ist,
insbesondere wobei mit der Heizeinrichtung (33) zumindest das Teilstück der Wand auf ihrer der Umgebung zugewandten Seite auf eine Temperatur von wenigstens 10°C aufheizbar ist.

8. NMR-Messanordnung (20) nach einem der vorhergehenden Ansprüche,
**dadurch gekennzeichnet, dass** zumindest das Teilstück der Wand (12) der Bohrung (10) vom übrigen Vakuumbehälter, entsprechend einem Raumtemperatur-Mantel (26) des Vakuumbehälters (5), weitgehend thermisch entkoppelt ist, so dass eine verbleibende thermische Kopplung kleiner als 0,1 W/K ist.

9. NMR-Messanordnung (20) nach Anspruch 8, **dadurch gekennzeichnet, dass** die Wand (12) der Bohrung (10) bezüglich der Längsrichtung (LR) in einem mittleren Teilbereich (12a) aus einem Material mit höherer spezifischer thermischer Leitfähigkeit und/oder mit einer größeren Wandstärke gefertigt ist als in zwei äußeren Teilbereichen (12b-12c).

10. NMR-Messanordnung (20) nach einem der vorhergehenden Ansprüche,
**dadurch gekennzeichnet, dass** die Wärmesenke, an die zumindest das Teilstück der Wand (12) der Bohrung (10) thermisch gekoppelt ist,
- ein Stickstoffbehälter (6) des Kryostaten (1) oder ein mit dem Stickstoffbehälter (6) verbundener Strahlungsschild (7) des Kryostaten (1) ist, oder
- eine wärmere Kühlstufe (61) eines Kryokühlers (60) oder ein mit einer wärmeren Kühlstufe (61) eines Kryokühlers (60) verbundener Strahlungsschild (7) ist, insbesondere wobei der Kryokühler (60) als Pulsrohrkühler ausgebildet ist, oder
- ein Strahlungsschild, welcher durch abdampfendes Helium aus einem Kryobehälter (9) gekühlt wird, wobei der Kryobehälter (9) im Vakuumbehälter (5) angeordnet ist und das Magnetspulensystem (2) enthält.

11. NMR-Messanordnung (20) nach einem der vorhergehenden Ansprüche,
**dadurch gekennzeichnet, dass** zumindest das Teilstück der Wand (12) der Bohrung (10) thermisch gekoppelt ist an
- zumindest einen Teil des NMR-Probenkopfs (3), und/oder
- ein Gradienten-Spulensystem (16), welches separat vom Probenkopf (3) oder als Teil des Probenkopfs (3) in der Bohrung (10) angeordnet ist, und/oder
- ein Shim-Spulensystem (14), welches separat vom Probenkopf (3) oder als Teil des Probenkopfs (3) in der Bohrung (10) angeordnet ist.

12. Verwendung einer NMR-Messanordnung (20) nach einem der vorhergehenden Ansprüche, **dadurch gekennzeichnet,**
**dass** an einer im NMR-Probenkopf (3) angeordnete Messprobe (11) eine NMR-Messung durchgeführt wird,
wobei während der Messung zumindest das Teilstück der Wand (12) der Bohrung (10) auf eine Temperatur T_{wand}<250K, insbesondere T_{wand}<100K, abgekühlt ist, und die Bohrung (10) zumindest im Bereich des Teilstücks evakuiert ist oder mit einem Trockengas befüllt ist oder mit einem Trockengas gespült wird.

13. Verwendung nach Anspruch 12, **dadurch gekennzeichnet, dass** während der Messung zumindest ein Teil des NMR-Probenkopfs (3) durch thermische Kopplung zumindest an das Teilstück der Wand (12) der Bohrung (10) gekühlt wird.

14. Verwendung nach einem der Ansprüche 12 oder 13, **dadurch gekennzeichnet, dass** zumindest ein Teil des NMR-Probenkopfs (3) mittels einer eigenen Kühlvorrichtung (25) gekühlt wird, wobei zumindest das Teilstück der Wand (12) der Bohrung (10) einen Eintrag von Wärmestrahlung in den NMR-Probenkopf (3) begrenzt.

15. Verwendung einer NMR-Messanordnung (20) nach Anspruch 3, **dadurch gekennzeichnet, dass** der NMR-Probenkopf (3) an der NMR-Messanordnung (20) gewechselt wird, wobei ein erster NMR-Probenkopf (3) aus der Bohrung (10) ausgeführt und durch die Schleusenkammer (54) ausgeschleust wird und ein zweiter NMR-Probenkopf (3) durch die Schleusenkammer (54) eingeschleust und zumindest teilweise in die Bohrung (10) eingeführt wird, und währenddessen in der Bohrung (10) zumindest im Bereich des Teilstücks der Wand (12) der Bohrung (10) ein Vakuum oder eine Trockengasfüllung vorgehalten wird.

16. Verwendung einer NMR-Messanordnung (20) nach Anspruch 6, **dadurch gekennzeichnet, dass** der NMR-Probenkopf (3) an der NMR-Messanordnung (20) gewechselt wird, wobei ein erster NMR-Probenkopf (3) aus der Bohrung (10) ausgeführt und ein zweiter NMR-Probenkopf (3) zumindest teilweise in die Bohrung (10) eingeführt wird, und währenddessen die Bohrung (10) zumindest im Bereich des Teilstücks mit einem trockenen Gas, insbesondere trockenem Stickstoff oder trockenem Helium, mit der Trockengas-Spüleinrichtung (41) gespült wird.

17. Verwendung einer NMR-Messanordnung (20) nach Anspruch 7, **dadurch gekennzeichnet, dass** der NMR-Probenkopf (3) an der NMR-Messanordnung (20) gewechselt wird, wobei ein erster NMR-Probenkopf (3) aus der Bohrung (10) ausgeführt und ein zweiter NMR-Probenkopf (3) zumindest teilweise in die Bohrung (10) eingeführt wird, und währenddessen die Bohrung (10) zumindest im Bereich des Teilstücks mit der Heizeinrichtung (33) beheizt wird, so dass an der Wand (12) der Bohrung (10) eine Kondenswasserbildung vermieden wird, insbesondere wobei die Wand (12) der Bohrung (10) zumindest im Bereich des Teilstücks auf ihrer der Umgebung zugewandten Seite eine Temperatur von wenigstens 10°C aufweist.

## Claims

1. NMR measuring arrangement (20), comprising
- a cryostat (1) having an evacuated vacuum container (5), wherein the cryostat (1) forms a bore (10), and wherein a wall (12) of the bore (10) also delimits the vacuum container (5),
- a superconducting magnet coil system (2) having a magnet bore (17), wherein the magnet coil system (2) is arranged directly or indirectly inside the vacuum container (5), wherein the cryostat (1), for the thermal insulation of the magnet coil system (2), locally forms one or more evacuated gaps (13, 21a-21c) between the superconducting magnetic coil system (2) and the vacuum container (5) in a sequence from the inside out, and wherein the bore (10) extends through the magnet bore (17),
- an NMR probehead (3) having an HF coil system (15), wherein the NMR probehead (3) is arranged outside the vacuum container (5), and wherein the NMR probehead (3) is at least partially arranged in the bore (10),
wherein the cryostat (1) forms only one evacuated gap (13) in the space (18) between the magnet coil system (2) and the wall (12) of the bore (10) in a sequence from the inside out, starting from the magnet coil system (2) towards the vacuum container (5),
wherein at least a segment of the wall (12) of the bore (10) is thermally coupled to a heat sink of the cryostat (1), and
wherein the wall (12) of the bore (10) also delimits a hermetically sealed space (19) outside the vacuum container (5), wherein this sealed space (19) extends in the bore (10) in the longitudinal direction (LR) at least over the length of the segment.

2. NMR measuring arrangement (20) according to claim 1, **characterized in that** the wall (12) of the bore (10) and a housing wall (30a) of the NMR probehead (3) are sealed against one another with one or more seals, in particular radial seals (31a-31b).

3. NMR measuring arrangement (20) according to claim 1 or 2, **characterized in that** a lock chamber (54) is formed at an opening of the bore (10), wherein the NMR probehead (3) is introduceable through the lock chamber (54) for an at least partial arrangement in the bore (10) and dischargeable again.

4. NMR measuring arrangement (20) according to any of claims 1 to 3, **characterized in that** a pump device (50) is provided with which the sealed space (19) is evacuable.

5. NMR measuring arrangement (20) according to any of claims 1 to 4, **characterized in that** a dry gas filling device (41a) is present with which the sealed space (19) is fillable with a dry gas, in particular dry nitrogen or dry helium.

6. NMR measuring arrangement (20) according to any of the preceding claims, **characterized in that** the cryostat (1) is provided with a dry gas flushing device (41) with which the bore (10) is flushable with a dry gas, in particular dry nitrogen or dry helium, at least in the region of the segment.

7. NMR measuring arrangement (20) according to any of the preceding claims, **characterized in that** the wall (12) of the bore (10) is provided with a heating device (33), in particular an electrical heating device, with which at least the segment of the wall (12) of the bore (10) is heatable,
in particular wherein at least the segment of the wall on its side facing the environment is heatable with the heating device (33) to a temperature of at least 10°C.

8. NMR measuring arrangement (20) according to any of the preceding claims, **characterized in that** at least the segment of the wall (12) of the bore (10) is largely thermally decoupled from the rest of the vacuum container (26) corresponding to a room temperature shell (26) of the vacuum container (5) such that a remaining thermal coupling is less than 0.1 W/K.

9. NMR measuring arrangement (20) according to claim 8, **characterized in that** the wall (12) of the bore (10), in a central portion (12a) with respect to the longitudinal direction (LR), is made from a material with a higher specific thermal conductivity and/or with a greater wall thickness than in two outer portions (12b-12c).

10. NMR measuring arrangement (20) according to any of the preceding claims, **characterized in that** the heat sink, to which at least the segment of the wall (12) of the bore (10) is thermally coupled,
- is a nitrogen container (6) of the cryostat (1) or a radiation shield (7) of the cryostat (1) connected to the nitrogen container (6), or
- a warmer cooling stage (61) of a cryocooler (60) or a radiation shield (7) connected to a warmer cooling stage (61) of a cryocooler (60), in particular wherein the cryocooler (60) is designed as a pulse tube cooler, or
- a radiation shield which is cooled by evaporating helium from a cryogenic container (9), wherein the cryogenic container (9) is arranged in the vacuum container (5) and contains the magnet coil system (2).

11. NMR measuring arrangement (20) according to any of the preceding claims, **characterized in that** at least the segment of the wall (12) of the bore (10) is thermally coupled to
- at least part of the NMR probehead (3), and/or
- a gradient coil system (16) which is arranged separately from the probehead (3) or as part of the probehead (3) in the bore (10), and/or
- a shim coil system (14) which is arranged separately from the probehead (3) or as part of the probehead (3) in the bore (10).

12. Use of an NMR measuring arrangement (20) according to any of the preceding claims, **characterized in that**
an NMR measurement is carried out on a measurement sample (11) arranged in the NMR probehead (3),
wherein, during the measurement, at least the segment of the wall (12) of the bore (10) is cooled to a temperature T_{wall} <250K, in particular T_{wall} <100K, and the bore (10) is evacuated or is filled with a dry gas or is flushed with a dry gas at least in the region of the segment.

13. Use according to claim 12, **characterized in that** at least part of the NMR probehead (3) is cooled during the measurement by thermal coupling to at least the segment of the wall (12) of the bore (10).

14. Use according to any of claims 12 or 13, **characterized in that** at least part of the NMR probehead (3) is cooled by means of its own cooling device (25), wherein at least the segment of the wall (12) of the bore (10) limits an input of thermal radiation into the NMR probehead (3).

15. Use of an NMR measuring arrangement (20) according to claim 3, **characterized in that** the NMR probehead (3) is changed on the NMR measuring arrangement (20), wherein a first NMR probehead (3) is removed from the bore (10) and discharged through the lock chamber (54), and a second NMR probehead (3) is introduced through the lock chamber (54) and at least partially inserted into the bore (10), while a vacuum or a dry gas filling is maintained in the bore (10) at least in the region of the segment of the wall (12) of the bore (10).

16. Use of an NMR measuring arrangement (20) according to claim 6, **characterized in that** the NMR probehead (3) is changed on the NMR measuring arrangement (20), wherein a first NMR probehead (3) is removed from the bore (10) and a second NMR probehead (3) is at least partially inserted into the bore (10), while the bore (10) is flushed at least in the region of the segment with a dry gas, in particular dry nitrogen or dry helium, using the dry gas flushing device (41).

17. Use of an NMR measuring arrangement (20) according to claim 7, **characterized in that** the NMR probehead (3) is changed on the NMR measuring arrangement (20), wherein a first NMR probehead (3) is removed from the bore (10) and a second NMR probehead (3) is at least partially inserted into the bore (10), while the bore (10) is heated with the heating device (33) at least in the region of the segment, so that a formation of condensation is avoided on the wall (12) of the bore (10), in particular wherein the wall (12) of the bore (10) at least in the region of the segment on its the side facing the environment has a temperature of at least 10°C.

## Revendications

1. Ensemble de mesure RMN (20), comprenant
- un cryostat (1), avec un contenant sous vide évacué (5), le cryostat (1) formant un alésage (10), et une paroi (12) de l'alésage (10) délimitant le contenant sous vide (5),
- un système de bobines magnétiques supraconductrices (2), avec un alésage magnétique (17), le système de bobines magnétiques (2) étant agencé directement ou indirectement à l'intérieur du contenant sous vide (5), le cryostat (1) formant localement un ou plusieurs espaces interstitiels évacués (13, 21a - 21c) en succession de l'intérieur vers l'extérieur entre le système de bobines magnétiques supraconductrices (2) et le contenant vide (5) pour l'isolation thermique du système de bobines magnétiques (2), et l'alésage (10) s'étendant à travers l'alésage magnétique (17),
- une tête d'échantillonnage RMN (3), avec un système de bobines HF (15), la tête d'échantillonnage RMN (3) étant agencée à l'extérieur du contenant sous vide (5), et la tête d'échantillonnage RMN (3) étant agencée au moins partiellement dans l'alésage (10),
le cryostat (1) formant uniquement un espace interstitiel évacué (13) dans l'espace intermédiaire (18) entre le système de bobines magnétiques (2) et la paroi (12) de l'alésage (10) en succession de l'intérieur vers l'extérieur, en partant du système de bobines magnétiques (2) vers le contenant sous vide (5),
au moins une pièce partielle de la paroi (12) de l'alésage (10) étant couplée thermiquement à un dissipateur thermique du cryostat (1), et
la paroi (12) de l'alésage (10) délimitant un espace hermétiquement étanchéifié (19) à l'extérieur du contenant sous vide (5), cet espace étanchéifié (19) s'étendant dans l'alésage (10) dans la direction longitudinale (LR) au moins sur la longueur de la pièce partielle.

2. Ensemble de mesure RMN (20) selon la revendication 1, **caractérisé en ce que** la paroi (12) de l'alésage (10) et une paroi de boîtier (30a) de la tête d'échantillonnage RMN (3) sont étanchéifiées l'une par rapport à l'autre avec un ou plusieurs joints d'étanchéité, notamment joints d'étanchéité radiaux (31a-31b) .

3. Ensemble de mesure RMN (20) selon la revendication 1 ou 2, **caractérisé en ce qu'**une chambre de sas (54) est formée au niveau d'une ouverture de l'alésage (10), à travers laquelle la tête d'échantillonnage RMN (3) peut être introduite pour être agencée au moins partiellement dans l'alésage (10) et de nouveau retirée.

4. Ensemble de mesure RMN (20) selon l'une quelconque des revendications 1 à 3, **caractérisé en ce qu'**un dispositif de pompage (50) est prévu, avec lequel l'espace étanchéifié (19) peut être évacué.

5. Ensemble de mesure RMN (20) selon l'une quelconque des revendications 1 à 4, **caractérisé en ce qu'**un dispositif de remplissage de gaz sec (41a) est présent, avec lequel l'espace étanchéifié (19) peut être rempli avec un gaz sec, notamment de l'azote sec ou de l'hélium sec.

6. Ensemble de mesure RMN (20) selon l'une quelconque des revendications précédentes, **caractérisé en ce que** le cryostat (1) est pourvu d'un dispositif de balayage de gaz sec (41), avec lequel l'alésage (10) peut être balayé avec un gaz sec, notamment de l'azote sec ou de l'hélium sec, au moins dans la zone de la pièce partielle.

7. Ensemble de mesure RMN (20) selon l'une quelconque des revendications précédentes, **caractérisé en ce que** la paroi (12) de l'alésage (10) est pourvue d'un dispositif de chauffage (33), notamment d'un dispositif de chauffage électrique, avec lequel au moins la pièce partielle de la paroi (12) de l'alésage (10) peut être chauffée,
le dispositif de chauffage (33) permettant notamment de chauffer au moins la pièce partielle de la paroi sur son côté tourné vers l'environnement à une température d'au moins 10 °C.

8. Ensemble de mesure RMN (20) selon l'une quelconque des revendications précédentes, **caractérisé en ce qu'**au moins la pièce partielle de la paroi (12) de l'alésage (10) est largement découplée thermiquement du reste du contenant sous vide, correspondant à une enveloppe à température ambiante (26) du contenant sous vide (5), de telle sorte qu'un couplage thermique restant est inférieur à 0,1 W/K.

9. Ensemble de mesure RMN (20) selon la revendication 8, **caractérisé en ce que** la paroi (12) de l'alésage (10) est fabriquée, par rapport à la direction longitudinale (LR), dans une zone partielle centrale (12a) en un matériau ayant une conductivité thermique spécifique plus élevée et/ou une épaisseur de paroi plus grande que dans deux zones partielles extérieures (12b-12c) .

10. Ensemble de mesure RMN (20) selon l'une quelconque des revendications précédentes, **caractérisé en ce que** le dissipateur thermique auquel au moins la pièce partielle de la paroi (12) de l'alésage (10) est couplée thermiquement est
- un réservoir d'azote (6) du cryostat (1) ou un écran de rayonnement (7) du cryostat (1) relié au réservoir d'azote (6), ou
- un étage de refroidissement plus chaud (61) d'un cryorefroidisseur (60) ou un écran de rayonnement (7) relié à un étage de refroidissement plus chaud (61) d'un cryorefroidisseur (60), le cryorefroidisseur (60) étant notamment configuré sous forme de refroidisseur à tube pulsé, ou
- un écran de rayonnement, qui est refroidi par de l'hélium s'évaporant d'un cryoréservoir (9), le cryoréservoir (9) étant agencé dans le contenant sous vide (5) et contenant le système de bobines magnétiques (2) .

11. Ensemble de mesure RMN (20) selon l'une quelconque des revendications précédentes, **caractérisé en ce qu'**au moins la pièce partielle de la paroi (12) de l'alésage (10) est couplée thermiquement à
- au moins une partie de la tête d'échantillonnage RMN (3), et/ou
- un système de bobines à gradient (16), qui est agencé dans l'alésage (10) séparément de la tête d'échantillonnage (3) ou en tant que partie de la tête d'échantillonnage (3),
et/ou
- un système de bobines de shim (14), qui est agencé dans l'alésage (10) séparément de la tête d'échantillonnage (3) ou en tant que partie de la tête d'échantillonnage (3).

12. Utilisation d'un ensemble de mesure RMN (20) selon l'une quelconque des revendications précédentes, **caractérisée en ce que**
une mesure RMN est effectuée sur un échantillon de mesure (11) agencé dans la tête d'échantillonnage RMN (3),
pendant la mesure, au moins la pièce partielle de la paroi (12) de l'alésage (10) étant refroidie à une température Tₚₐᵣₒᵢ < 250 K, notamment Tₚₐᵣₒᵢ < 100 K, et l'alésage (10) étant évacué au moins dans la zone de la pièce partielle ou étant rempli avec un gaz sec ou étant balayé avec un gaz sec.

13. Utilisation selon la revendication 12, **caractérisée en ce que**, pendant la mesure, au moins une partie de la tête d'échantillonnage RMN (3) est refroidie par couplage thermique avec au moins la pièce partielle de la paroi (12) de l'alésage (10).

14. Utilisation selon l'une quelconque des revendications 12 ou 13, **caractérisée en ce qu'**au moins une partie de la tête d'échantillonnage RMN (3) est refroidie au moyen d'un dispositif de refroidissement (25) propre, au moins la pièce partielle de la paroi (12) de l'alésage (10) limitant une entrée de rayonnement de chaleur dans la tête d'échantillonnage RMN (3).

15. Utilisation d'un ensemble de mesure RMN (20) selon la revendication 3, **caractérisée en ce que** la tête d'échantillonnage RMN (3) est changée sur l'ensemble de mesure RMN (20), une première tête d'échantillonnage RMN (3) étant sortie de l'alésage (10) et retirée par la chambre de sas (54) et une deuxième tête d'échantillonnage RMN (3) étant introduite par la chambre de sas (54) et insérée au moins partiellement dans l'alésage (10), et pendant ce temps, un vide ou un remplissage de gaz sec étant maintenu dans l'alésage (10) au moins dans la zone de la pièce partielle de la paroi (12) de l'alésage (10).

16. Utilisation d'un ensemble de mesure RMN (20) selon la revendication 6, **caractérisée en ce que** la tête d'échantillonnage RMN (3) est changée sur l'ensemble de mesure RMN (20), une première tête d'échantillonnage RMN (3) étant sortie de l'alésage (10) et une deuxième tête d'échantillonnage RMN (3) étant insérée au moins partiellement dans l'alésage (10), et pendant ce temps, l'alésage (10) étant balayé, au moins dans la zone de la pièce partielle, avec un gaz sec, notamment de l'azote sec ou de l'hélium sec, avec le dispositif de balayage de gaz sec (41).

17. Utilisation d'un ensemble de mesure RMN (20) selon la revendication 7, **caractérisée en ce que** la tête d'échantillonnage RMN (3) est changée sur l'ensemble de mesure RMN (20), une première tête d'échantillonnage RMN (3) étant sortie de l'alésage (10) et une deuxième tête d'échantillonnage RMN (3) étant insérée au moins partiellement dans l'alésage (10), et pendant ce temps, l'alésage (10) étant chauffé au moins dans la zone de la pièce partielle avec le dispositif de chauffage (33), de telle sorte qu'une formation d'eau de condensation est évitée sur la paroi (12) de l'alésage (10), la paroi (12) de l'alésage (10) présentant notamment, au moins dans la zone de la pièce partielle, une température d'au moins 10 °C sur son côté tourné vers l'environnement.
